(19) 

**Europäisches Patentamt**
**European Patent Office**
**Office européen des brevets**

(11) **EP 4 586 566 A1**

(12) **EUROPEAN PATENT APPLICATION**
published in accordance with Art. 153(4) EPC

(43) Date of publication:
**16.07.2025 Bulletin 2025/29**

(21) Application number: **22960413.7**

(22) Date of filing: **30.09.2022**

(51) International Patent Classification (IPC):
*H04L 27/00* (2006.01)    *G06T 9/00* (2006.01)
*H04N 19/10* (2014.01)

(52) Cooperative Patent Classification (CPC):
**G06T 9/00; H04L 27/00; H04N 19/10**

(86) International application number:
**PCT/CN2022/123574**

(87) International publication number:
**WO 2024/065803 (04.04.2024 Gazette 2024/14)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **Huawei Technologies Co., Ltd.**
**Shenzhen, Guangdong 518129 (CN)**

(72) Inventors:
• **DU, Yuqing**
  **Shenzhen, Guangdong 518129 (CN)**
• **MA, Mengyao**
  **Shenzhen, Guangdong 518129 (CN)**
• **XIE, Junwen**
  **Shenzhen, Guangdong 518129 (CN)**
• **DU, Yinggang**
  **Shenzhen, Guangdong 518129 (CN)**

(74) Representative: **Pfenning, Meinig & Partner mbB**
**Patent- und Rechtsanwälte**
**Theresienhöhe 11a**
**80339 München (DE)**

(54) **DATA COMPRESSION TRANSMISSION METHOD, APPARATUS, DEVICE, AND STORAGE MEDIUM**

(57)     This application provides a data compression and transmission method, an apparatus, a device, and a storage medium. The method includes: A first communication apparatus decomposes an $i^{th}$ piece of subdata $Y_i$ in M pieces of subdata into a dictionary matrix $D_i$ and a sparse matrix $X_i$, where the sparse matrix $X_i$ is used to express the $i^{th}$ piece of subdata $Y_i$ based on the dictionary matrix $D_i$, the M pieces of subdata are included in to-be-transmitted first data, M is an integer greater than or equal to 1, and i is an integer greater than or equal to 1 and less than or equal to M; performs data compression based on the dictionary matrix $D_i$ and the sparse matrix $X_i$, to obtain compressed data $Z_i$ of the $i^{th}$ piece of subdata $Y_i$; and then sends the compressed data $Z_i$ to a second communication apparatus. This implements effective and reliable data compression and transmission on the first data with a large data amount.

200

| First communication apparatus | | Second communication apparatus |
|---|---|---|

S210: Decompose an $i^{th}$ piece of subdata $Y_i$ in M pieces of subdata into a dictionary matrix $D_i$ and a sparse matrix $X_i$, where the dictionary matrix $D_i$ includes a feature of the $i^{th}$ piece of subdata $Y_i$, the sparse matrix $X_i$ is used to express the $i^{th}$ piece of subdata $Y_i$ based on the dictionary matrix $D_i$, and the M pieces of subdata are included in to-be-transmitted first data

S220: Perform data compression based on the dictionary matrix $D_i$ and the sparse matrix $X_i$, to obtain compressed data $Z_i$ of the $i^{th}$ piece of subdata $Y_i$

S230: Send the compressed data $Z_i$

S240: Determine a dictionary matrix $D_i'$ and a sparse matrix $X_i'$ based on the compressed data $Z_i$, where the dictionary matrix $D_i'$ includes the feature of the $i^{th}$ piece of subdata $Y_i$, and the sparse matrix $X_i'$ is used to express the $i^{th}$ piece of subdata $Y_i$ based on the dictionary matrix $D_i'$

S250: Construct an $i^{th}$ piece of subdata $Y_i'$ in M pieces of subdata of second data based on the dictionary matrix $D_i'$ and the sparse matrix $X_i'$

FIG. 3

EP 4 586 566 A1

**Description**

**TECHNICAL FIELD**

This application relates to the field of communication technologies, and in particular, to a data compression and transmission method, an apparatus, a device, and a storage medium.

**BACKGROUND**

Currently, in some communication scenarios, for example, a point cloud data transmission scenario or an artificial intelligence (artificial intelligence, AI) model data (AI model data for short below) transmission scenario, when data transmitted between communication devices is large, a large quantity of transmission resources are occupied, and a transmission delay is increased. In view of this, before data is transmitted, data compression may be performed on the to-be-transmitted data through scalar quantization or vector quantization, and then the compressed data is transmitted, to save the transmission resources and reduce the transmission delay. However, performing data compression on the to-be-transmitted data through scalar quantization or vector quantization results in a low compression rate and a large data loss of the compressed data. Therefore, how to implement effective and reliable data compression and transmission is an urgent problem to be resolved currently.

**SUMMARY**

Embodiments of this application provide a data compression and transmission method, an apparatus, a device, and a storage medium, to implement effective and reliable data compression and transmission.

According to a first aspect, this application provides a data compression and transmission method, including: A first communication apparatus decomposes an $i^{th}$ piece of subdata $Y_i$ in M pieces of subdata into a dictionary matrix $D_i$ and a sparse matrix $X_i$, where the dictionary matrix $D_i$ includes a feature of the $i^{th}$ piece of subdata $Y_i$, the sparse matrix $X_i$ is used to express the $i^{th}$ piece of subdata $Y_i$ based on the dictionary matrix $D_i$, the M pieces of subdata are included in to-be-transmitted first data, M is an integer greater than or equal to 1, and i is an integer greater than or equal to 1 and less than or equal to M; the first communication apparatus performs data compression based on the dictionary matrix $D_i$ and the sparse matrix $X_i$, to obtain compressed data $Z_i$ of the $i^{th}$ piece of subdata $Y_i$; and the first communication apparatus sends the compressed data $Z_i$ to a second communication apparatus.

According to the data compression and transmission method provided in the first aspect, the first communication apparatus splits the to-be-transmitted first data into the M pieces of subdata, decomposes the $i^{th}$ piece of subdata $Y_i$ in the M pieces of subdata into the dictionary matrix $D_i$ and the sparse matrix $X_i$, further performs data compression based on the dictionary matrix $D_i$ and the sparse matrix $X_i$, to obtain the compressed data $Z_i$ of the $i^{th}$ piece of subdata $Y_i$, and then sends the compressed data $Z_i$ of the $i^{th}$ piece of subdata $Y_i$ to the second communication apparatus. The $i^{th}$ piece of subdata $Y_i$ is expressed by using the sparse matrix $X_i$ based on the dictionary matrix $D_i$, so that in a communication scenario in which a large amount of data is transmitted, effective and reliable data compression and transmission can be implemented on the first data with a large data amount.

In a possible implementation, that the first communication apparatus performs data compression based on the dictionary matrix $D_i$ and the sparse matrix $X_i$, to obtain the compressed data $Z_i$ of the $i^{th}$ piece of subdata $Y_i$ includes: The first communication apparatus determines first location indication information and a first element sequence that are of the sparse matrix $X_i$, where the first location indication information indicates whether an element in the sparse matrix $X_i$ has a first capability of expressing the $i^{th}$ piece of subdata $Y_i$, and the first element sequence includes an element that has the first capability of expressing the $i^{th}$ piece of subdata $Y_i$; or the first location indication information indicates whether a first element in the sparse matrix $X_i$ has a first capability of expressing the $i^{th}$ piece of subdata $Y_i$, elements in the sparse matrix $X_i$ include the first element, and the first element sequence includes an first element that has the first capability of expressing the $i^{th}$ piece of subdata $Y_i$; and the first communication apparatus performs data compression on the dictionary matrix $D_i$, and the first location indication information and the first element sequence that are of the sparse matrix $X_i$, to obtain first compressed data $Z_i'$ of the $i^{th}$ piece of subdata $Y_i$.

In this implementation, an element or a first element that has the first capability of expressing the $i^{th}$ piece of subdata $Y_i$, and location indication information that indicates the element or the first element that has the first capability of expressing the $i^{th}$ piece of subdata $Y_i$ are reserved, and an element or a first element that does not have the first capability of expressing the $i^{th}$ piece of subdata $Y_i$ is deleted, so that a compression rate of the first compressed data $Z_i'$ can be improved.

In a possible implementation, the first location indication information is a first bitmap; and bits in the first bitmap one-to-one correspond to the elements in the sparse matrix $X_i$, and a bit in the first bitmap indicates whether a corresponding element in the sparse matrix $X_i$ has the first capability of expressing the $i^{th}$ piece of subdata $Y_i$; or bits in the first bitmap one-to-one correspond to first elements in the sparse matrix $X_i$, and a bit in the first bitmap indicates whether a corresponding first element in the sparse matrix $X_i$ has the first capability of expressing the $i^{th}$ piece of subdata $Y_i$.

In this implementation, a location, in the sparse matrix $X_i$, of each element in the first element sequence is accurately indicated through the first bitmap.

In a possible implementation, that the first communication apparatus determines the first location indication information and the first element sequence that are of the sparse matrix $X_i$ includes: The first communication apparatus determines whether each element in the sparse matrix $X_i$ has the first capability of expressing the $i^{th}$ piece of subdata $Y_i$ based on the element and a first capability threshold; and the first communication apparatus determines the first location indication information and the first element sequence based on whether each element in the sparse matrix $X_i$ has the first capability of expressing the $i^{th}$ piece of subdata $Y_i$.

In this implementation, whether each element in the sparse matrix $X_i$ has the first capability can be accurately identified.

In a possible implementation, the first location indication information of the sparse matrix $X_i$ is differentiated location indication information obtained by performing exclusive OR on first location indication information of the $i^{th}$ piece of subdata $Y_i$ and first location indication information of an $(i-1)^{th}$ piece of subdata $Y_{i-1}$; and the differentiated location indication information is used as the first location indication information of the sparse matrix $X_i$.

In this implementation, compression performance can be further improved.

In a possible implementation, the differentiated location indication information is a differentiated bitmap; and that the differentiated location indication information is used as the first location indication information of the sparse matrix $X_i$ includes: When a first proportion of the differentiated location indication information is greater than or equal to a proportion threshold, the first communication apparatus uses the differentiated location indication information as the first location indication information of the sparse matrix $X_i$, where the first proportion is a proportion of a quantity of bits with a first value or a second value in bits of the differentiated location indication information to a quantity of all the bits of the differentiated location indication information, the first value indicates that a corresponding element in the sparse matrix $X_i$ has the first capability of expressing the $i^{th}$ piece of subdata $Y_i$, and the second value indicates that a corresponding element in the sparse matrix $X_i$ does not have the first capability of expressing the $i^{th}$ piece of subdata $Y_i$.

In this implementation, when a compression rate of the differentiated location indication information is greater than a compression rate of the first location indication information, the first location indication information is replaced with the differentiated location indication information, to ensure that a compression rate can be improved by replacing the location indication information.

In a possible implementation, the first location indication information indicates whether the first element in the sparse matrix $X_i$ has the first capability of expressing the $i^{th}$ piece of subdata $Y_i$, the elements in the sparse matrix $X_i$ include a second element, and the second element is different from the first element; and the method further includes: The first communication apparatus determines second location indication information and a second element sequence that are of the sparse matrix $X_i$, where the second location indication information indicates whether a second element in the sparse matrix $X_i$ has the first capability of expressing the $i^{th}$ piece of subdata $Y_i$, and the second element sequence includes a second element that has the first capability of expressing the $i^{th}$ piece of subdata $Y_i$; and the first communication apparatus performs data compression on the second location indication information and the second element sequence, to obtain second compressed data $Z_i''$ of the $i^{th}$ piece of subdata $Y_i$, where the second compressed data $Z_i''$ is different from the first compressed data $Z_i'$.

In this implementation, the first communication apparatus performs compression and transmission on the second element that has the first capability and the second location indication information indicating a location of the second element, to avoid a case in which the second element sequence and the second location indication information cannot be transmitted due to limited transmission resources, or avoid a large difference between second data constructed by the second communication apparatus and the first data (that is, quality of the constructed second data is poor) due to insufficient content of the transmitted first data when only the first compressed data is transmitted.

In a possible implementation, the second location indication information is a second bitmap, bits in the second bitmap one-to-one correspond to second elements in the sparse matrix $X_i$, and the bits in the second bitmap indicate whether the corresponding second elements in the sparse matrix $X_i$ have the first capability of expressing the $i^{th}$ piece of subdata $Y_i$.

In this implementation, a location, in the sparse matrix $X_i$, of the second element that has the first capability is accurately indicated through the second bitmap.

In a possible implementation, the method further includes: The first communication apparatus determines third location indication information and a third element sequence that are of the sparse matrix $X_i$, where the third location indication information indicates whether an element in the sparse matrix $X_i$ has a second capability of expressing the $i^{th}$ piece of subdata $Y_i$, and the third element sequence includes an element that has the second capability of expressing the $i^{th}$ piece of subdata $Y_i$; the first communication apparatus performs data compression on the third location indication information and the third element sequence that are of the sparse matrix $X_i$, to obtain third compressed data $Z_i'''$ of the $i^{th}$ piece of subdata $Y_i$; and the first communication apparatus sends the third compressed data $Z_i'''$ to the second

communication apparatus.

In this implementation, the first communication apparatus performs compression and transmission on the element that has the second capability and the third location indication information indicating the element that has the second capability, to supplement content of the first data based on the first compressed data by transmitting the third compressed data, and avoid a large difference between second data constructed by the second communication apparatus and the first data (that is, quality of the constructed second data is poor).

In a possible implementation, the third location indication information is a third bitmap, bits in the third bitmap one-to-one correspond to the elements in the sparse matrix $X_i$, and the bits in the third bitmap indicate whether the corresponding elements in the sparse matrix $X_i$ have the second capability of expressing the $i^{th}$ piece of subdata $Y_i$.

In this implementation, an element that is in the sparse matrix $X_i$ and that has the second capability of expressing the $i^{th}$ piece of subdata $Y_i$ is accurately indicated through the third bitmap.

In a possible implementation, that the first communication apparatus determines the third location indication information and the third element sequence that are of the sparse matrix $X_i$ includes: The first communication apparatus determines whether each element in the sparse matrix $X_i$ has the second capability of expressing the $i^{th}$ piece of subdata $Y_i$ based on the element, the first capability threshold, and a second capability threshold; and the first communication apparatus determines the third location indication information and the third element sequence based on whether each element in the sparse matrix $X_i$ has the second capability of expressing the $i^{th}$ piece of subdata $Y_i$.

In this implementation, whether an element in the sparse matrix $X_i$ has the second capability is accurately identified.

In a possible implementation, the method further includes: The first communication apparatus determines a third element sequence of the sparse matrix $X_i$, where the third element sequence includes N elements in the sparse matrix $X_i$ other than an element included in the first element sequence, and N is a positive integer; the first communication apparatus performs data compression on the third element sequence, to obtain third compressed data $Z_i'''$ of the $i^{th}$ piece of subdata $Y_i$; and the first communication apparatus sends the third compressed data $Z_i'''$ to the second communication apparatus.

In this implementation, the second compressed data does not include location indication information, thereby reducing resource overheads.

In a possible implementation, the N elements are elements in preset rows/columns in the sparse matrix $X_i$.

This implementation helps the first communication device and the second communication device agree on locations of the N elements.

In a possible implementation, quantities of columns of matrices formed by the M pieces of subdata are the same.

In this implementation, data processing complexity of the first communication apparatus and the second communication apparatus can be reduced.

In a possible implementation, the first data includes point cloud data, and the M pieces of subdata are obtained by splitting the first data based on distances between spatial points in the first data in Euclidean space; or the first data includes artificial intelligence AI model data, and the M pieces of subdata are obtained by splitting the first data based on neural network layers at which pieces of data in the first data are located.

In this implementation, data processing complexity of the first communication apparatus and the second communication apparatus can be reduced.

In a possible implementation, the first data includes the point cloud data, and the method further includes: The first communication apparatus performs, by using cubes with a preset side length, spatial division on Euclidean space in which initial point cloud data is located, and uses a geometric center of spatial points in a cube as a sampling point of the cube; and the first communication apparatus determines the first data based on sampling points of the cubes.

In this implementation, a data amount of the point cloud data is reduced, to improve compression and transmission efficiency of the point cloud data.

In a possible implementation, the method further includes: The first communication apparatus sends an upload request to the second communication apparatus, where the upload request carries first indication information, and the first indication information indicates a data type of the first data.

This implementation helps the second communication apparatus determine, based on the first indication information, a time-frequency resource used to transmit compressed first data, so that the time-frequency resource that is of the compressed first data and that is configured by the second communication apparatus meets the data type of the first data, thereby facilitating transmission of the compressed first data.

Optionally, the data type includes point cloud data or AI model data.

In a possible implementation, the method further includes: The first communication apparatus receives resource configuration information sent by the second communication apparatus, where the resource configuration information indicates a time-frequency resource of compressed data of the M pieces of subdata; and the first communication apparatus sends compressed first data on the time-frequency resource.

According to the data compression and transmission method provided in this implementation, a transmission resource for the compressed data is flexibly configured.

In a possible implementation, the method further includes: The first communication apparatus determines a compression parameter based on the time-frequency resource of the first data; and the first communication apparatus performs data compression on the $i^{th}$ piece of subdata $Y_i$ based on the compression parameter, to obtain the compressed data $Z_i$, where the compression parameter includes at least one of the following: the first capability threshold, where the first capability threshold is used to determine whether an element in the sparse matrix $X_i$ has the first capability of expressing the $i^{th}$ piece of subdata $Y_i$; the second capability threshold, where the second capability threshold is used to determine whether an element in the sparse matrix $X_i$ has the second capability of expressing the $i^{th}$ piece of subdata $Y_i$; a coding scheme parameter; a quantization precision parameter; or a quantity of columns of subdata.

According to the data compression and transmission method provided in this implementation, the compression parameter is determined based on the time-frequency resource of the first data, thereby reducing signaling overheads for configuring the compression parameter.

In a possible implementation, the method further includes: The first communication apparatus sends second indication information to the second communication apparatus, where the second indication information indicates at least one of the following: the first capability threshold, where the first capability threshold is used to determine whether an element in the sparse matrix $X_i$ has the first capability of expressing the $i^{th}$ piece of subdata $Y_i$; the second capability threshold, where the second capability threshold is used to determine whether an element in the sparse matrix $X_i$ has the second capability of expressing the $i^{th}$ piece of subdata $Y_i$; a proportion of elements that are in the sparse matrix $X_i$ and that have the first capability of expressing the $i^{th}$ piece of subdata $Y_i$; a data loss of the compressed data $Z_i$ relative to the $i^{th}$ piece of subdata $Y_i$; a coding scheme parameter; a quantization precision parameter; a quantity of columns of subdata; or whether bitmap location indication information of the sparse matrix $X_i$ is differentiated location indication information.

According to the data compression and transmission method provided in this implementation, the second communication apparatus accurately restores the first data based on the received compressed first data, thereby improving stability of data transmission.

According to a second aspect, an embodiment of this application provides a data compression and transmission method, including: A second communication apparatus receives compressed data $Z_i$ of an $i^{th}$ piece of subdata $Y_i$ in M pieces of subdata sent by a first communication apparatus, where the M pieces of subdata are included in first data, M is an integer greater than or equal to 1, and i is an integer greater than or equal to 1 and less than or equal to M; the second communication apparatus determines a dictionary matrix $D_i'$ and a sparse matrix $X_i'$ based on the compressed data $Z_i$, where the dictionary matrix $D_i'$ includes a feature of the $i^{th}$ piece of subdata $Y_i'$, and the sparse matrix $X_i'$ is used to express the $i^{th}$ piece of subdata $Y_i'$ based on the dictionary matrix $D_i'$; and the second communication apparatus constructs an $i^{th}$ piece of subdata $Y_i'$ in M pieces of subdata of second data based on the dictionary matrix $D_i'$ and the sparse matrix $X_i'$.

In a possible implementation, the compressed data $Z_i$ includes first compressed data $Z_i'$, and that the second communication apparatus determines the dictionary matrix $D_i'$ and the sparse matrix $X_i'$ based on the compressed data $Z_i$ includes: The second communication apparatus decompresses the first compressed data $Z_i'$ to obtain the dictionary matrix $D_i'$, and first location indication information and a first element sequence that are of the sparse matrix $X_i'$, where the first location indication information indicates whether an element in the sparse matrix $X_i'$ has a first capability of expressing the $i^{th}$ piece of subdata $Y_i'$ in the M pieces of subdata of the first data, and the first element sequence includes an element that has the first capability of expressing the $i^{th}$ piece of subdata $Y_i'$; or the first location indication information indicates whether a first element in the sparse matrix $X_i'$ has a first capability of expressing the $i^{th}$ piece of subdata $Y_i'$, elements in the sparse matrix $X_i'$ include the first element, and the first element sequence includes a first element that has the first capability of expressing the $i^{th}$ piece of subdata $Y_i'$; and the second communication apparatus determines the sparse matrix $X_i'$ based on the first location indication information and the first element sequence that are of the sparse matrix $X_i'$.

In a possible implementation, the first location information is a first bitmap; and bits in the first bitmap one-to-one correspond to the elements in the sparse matrix $X_i'$, and a bit in the first bitmap indicates whether a corresponding element in the sparse matrix $X_i'$ has the first capability of expressing the $i^{th}$ piece of subdata $Y_i'$; or bits in the first bitmap one-to-one correspond to first elements in the sparse matrix $X_i'$, and a bit in the first bitmap indicates whether a corresponding first element in the sparse matrix $X_i'$ has the first capability of expressing the $i^{th}$ piece of subdata $Y_i'$.

In a possible implementation, the first location indication information of the sparse matrix $X_i'$ is differentiated location indication information obtained by performing exclusive OR on first location indication information of the $i^{th}$ piece of subdata and first location indication information of an $(i-1)^{th}$ piece of subdata.

In a possible implementation, the compressed data $Z_i$ further includes second compressed data $Z_i''$, and the first location indication information indicates whether the first element in the sparse matrix $X_i'$ has the first capability of expressing the $i^{th}$ piece of subdata $Y_i'$; and that the second communication apparatus determines the dictionary matrix $D_i'$ and the sparse matrix $X_i'$ based on the first compressed data $Z_i$ includes: The second communication apparatus decompresses the second compressed data $Z_i''$, to obtain second location indication information and a second element sequence that are of the sparse matrix $X_i'$, where the second location indication information indicates whether a second element in the sparse matrix $X_i'$ has the first capability of expressing the $i^{th}$ piece of subdata $Y_i'$, and the second element sequence includes a second element that has the first capability of expressing the $i^{th}$ piece of subdata $Y_i'$; and the second

communication apparatus determines the sparse matrix $X_i'$ based on the first location indication information, the first element sequence, the second location indication information, and the second element sequence that are of the sparse matrix $X_i'$.

In a possible implementation, the second location indication information is a second bitmap, bits in the second bitmap one-to-one correspond to second elements in the sparse matrix $X_i'$, and the bits in the second bitmap indicate whether the corresponding second elements in the sparse matrix $X_i'$ have the first capability of expressing the $i^{th}$ piece of subdata $Y_i$.

In a possible implementation, the compressed data $Z_i$ further includes third compressed data $Z_i'''$, and that the second communication apparatus determines the dictionary matrix $D_i'$ and the sparse matrix $X_i'$ based on the first compressed data $Z_i$ includes: The second communication apparatus decompresses the third compressed data $Z_i'''$, to obtain third location indication information and a third element sequence that are of the sparse matrix $X_i'$, where the third location indication information indicates whether an element in the sparse matrix $X_i'$ has a second capability of expressing the $i^{th}$ piece of subdata $Y_i$, and the second element sequence includes an element that has the second capability of expressing the $i^{th}$ piece of subdata $Y_i$; and the second communication apparatus determines the sparse matrix $X_i'$ based on the third location indication information and the third element sequence that are of the sparse matrix $X_i'$, and at least one of the following: the first location indication information and the first element sequence that are of the sparse matrix $X_i'$; and the second location indication information and the second element sequence that are of the sparse matrix $X_i'$.

In a possible implementation, the third location indication information is a third bitmap, bits in the third bitmap one-to-one correspond to the elements in the sparse matrix Xi', and the bits in the third bitmap indicate whether the corresponding elements in the sparse matrix $X_i'$ have the second capability of expressing the $i^{th}$ piece of subdata $Y_i$.

In a possible implementation, the compressed data $Z_i$ further includes third compressed data $Z_i'''$, and that the second communication apparatus determines the dictionary matrix $D_i'$ and the sparse matrix $X_i'$ based on the first compressed data $Z_i$ includes: The second communication apparatus decompresses the third compressed data $Z_i'''$, to obtain a third element sequence of the sparse matrix $X_i'$, where the third element sequence includes N elements in the sparse matrix $X_i'$ other than elements included in the first element sequence and/or the second element sequence, and N is a positive integer; and the second communication apparatus determines the sparse matrix $X_i'$ based on the third element sequence of the sparse matrix $X_i'$ and at least one of the following: the first location indication information and the first element sequence that are of the sparse matrix $X_i'$; and the second location indication information and the second element sequence that are of the sparse matrix $X_i'$.

In a possible implementation, the N elements are elements in preset rows/columns in a sparse matrix $X_i$.

In a possible implementation, quantities of columns of matrices formed by the M pieces of subdata are the same.

In a possible implementation, the first data includes point cloud data, and the M pieces of subdata are obtained by splitting the first data based on distances between spatial points in the first data in Euclidean space; or the first data includes artificial intelligence AI model data, and the M pieces of subdata are obtained by splitting the first data based on neural network layers at which pieces of data in the first data are located.

In a possible implementation, the method further includes: The second communication apparatus receives an upload request sent by the first communication apparatus, where the upload request carries first indication information, and the first indication information indicates a data type of the first data.

In a possible implementation, the data type includes point cloud data or AI model data.

In a possible implementation, the method further includes: The second communication apparatus sends first resource configuration information to the first communication apparatus, where the first resource configuration information indicates a first time-frequency resource of the compressed data of the M pieces of subdata; and the second communication apparatus transmits the compressed data $Z_i$ on the first time-frequency resource.

In a possible implementation, the method further includes: The second communication apparatus receives second indication information sent by the first communication apparatus, where the second indication information indicates at least one of the following:

the first capability threshold, where the first capability threshold is used to determine whether an element in the sparse matrix $X_i$ has the first capability of expressing the $i^{th}$ piece of subdata $Y_i$;

the second capability threshold, where the second capability threshold is used to determine whether an element in the sparse matrix $X_i$ has the second capability of expressing the $i^{th}$ piece of subdata $Y_i$;

a proportion of elements that are in the sparse matrix $X_i$ and that have the first capability of expressing the $i^{th}$ piece of subdata $Y_i$;

a data loss of the compressed data $Z_i$ relative to the $i^{th}$ piece of subdata $Y_i$ in the M pieces of subdata of the first data;

a coding scheme parameter;

a quantization precision parameter;

a quantity of columns of subdata; and

whether a bitmap of the sparse matrix $X_i$ is a differentiated bitmap.

In a possible implementation, the second data is point cloud data, and the method further includes: When a distance between two adjacent spatial points of the second data in Euclidean space is greater than or equal to a second distance threshold, the second communication apparatus performs interpolation between the two adjacent spatial points.

In a possible implementation, that the second communication apparatus performs interpolation between the two adjacent spatial points includes: The second communication apparatus adds a spatial point at an intersection point of a connection line between the two adjacent spatial points and a sideline of a circle, where the circle uses one of the two adjacent spatial points as a center of the circle, and uses a third distance threshold as a radius in the Euclidean space.

For beneficial effects of the data compression and transmission method provided in the second aspect and the possible implementations of the second aspect, refer to beneficial effects brought by the first aspect and the possible implementations of the first aspect. Details are not described herein again.

According to a third aspect, an embodiment of this application provides a communication apparatus, including: a processing module, configured to: decompose an $i^{th}$ piece of subdata $Y_i$ in M pieces of subdata into a dictionary matrix $D_i$ and a sparse matrix $X_i$, where the dictionary matrix $D_i$ includes a feature of the $i^{th}$ piece of subdata $Y_i$, the sparse matrix $X_i$ is used to express the $i^{th}$ piece of subdata $Y_i$ based on the dictionary matrix $D_i$, the M pieces of subdata are included in to-be-transmitted first data, M is an integer greater than or equal to 1, and i is an integer greater than or equal to 1 and less than or equal to M; and perform data compression based on the dictionary matrix $D_i$ and the sparse matrix $X_i$, to obtain compressed data $Z_i$ of the $i^{th}$ piece of subdata $Y_i$; and a transceiver module, configured to send the compressed data $Z_i$ to a second communication apparatus.

In a possible implementation, the processing module is specifically configured to: determine first location indication information and a first element sequence that are of the sparse matrix $X_i$, where the first location indication information indicates whether an element in the sparse matrix $X_i$ has a first capability of expressing the $i^{th}$ piece of subdata $Y_i$, and the first element sequence includes an element that has the first capability of expressing the $i^{th}$ piece of subdata $Y_i$; or the first location indication information indicates whether a first element in the sparse matrix $X_i$ has a first capability of expressing the $i^{th}$ piece of subdata $Y_i$, elements in the sparse matrix $X_i$ include the first element, and the first element sequence includes a first element that has the first capability of expressing the $i^{th}$ piece of subdata $Y_i$; and perform data compression on the dictionary matrix $D_i$, and the first location indication information and the first element sequence that are of the sparse matrix $X_i$, to obtain first compressed data $Z_i'$ of the $i^{th}$ piece of subdata $Y_i$.

In a possible implementation, the first location indication information is a first bitmap; and bits in the first bitmap one-to-one correspond to the elements in the sparse matrix $X_i$, and a bit in the first bitmap indicates whether a corresponding element in the sparse matrix $X_i$ has the first capability of expressing the $i^{th}$ piece of subdata $Y_i$; or bits in the first bitmap one-to-one correspond to first elements in the sparse matrix $X_i$, and a bit in the first bitmap indicates whether a corresponding first element in the sparse matrix $X_i$ has the first capability of expressing the $i^{th}$ piece of subdata $Y_i$.

In a possible implementation, the processing module is specifically configured to: determine whether each element in the sparse matrix $X_i$ has the first capability of expressing the $i^{th}$ piece of subdata $Y_i$ based on the element and a first capability threshold; and determine the first location indication information and the first element sequence based on whether each element in the sparse matrix $X_i$ has the first capability of expressing the $i^{th}$ piece of subdata $Y_i$.

In a possible implementation, the processing module is further configured to: perform exclusive OR on the first location indication information of the sparse matrix $X_i$ and first location indication information of an $(i-1)^{th}$ piece of subdata $Y_{i-1}$, to obtain differentiated location indication information; and use the differentiated location indication information as the first location indication information of the sparse matrix $X_i$.

In a possible implementation, the processing module is specifically configured to: when a first proportion of the differentiated location indication information is greater than or equal to a proportion threshold, use the differentiated location indication information as the first location indication information of the sparse matrix $X_i$, where the first proportion is a proportion of a quantity of bits with a first value or a second value in bits of the differentiated location indication information to a quantity of all the bits of the differentiated location indication information, the first value indicates that a corresponding element in the sparse matrix $X_i$ has the first capability of expressing the $i^{th}$ piece of subdata $Y_i$, and the second value indicates that a corresponding element in the sparse matrix $X_i$ does not have the first capability of expressing the $i^{th}$ piece of subdata $Y_i$.

In a possible implementation, the first location indication information indicates whether the first element in the sparse matrix $X_i$ has the first capability of expressing the $i^{th}$ piece of subdata $Y_i$, the elements in the sparse matrix $X_i$ include a second element, and the second element is different from the first element; and the processing module is further configured to: determine second location indication information and a second element sequence that are of the sparse matrix $X_i$, where the second location indication information indicates whether a second element in the sparse matrix $X_i$ has the first capability of expressing the $i^{th}$ piece of subdata $Y_i$, and the second element sequence includes a second element that has the first capability of expressing the $i^{th}$ piece of subdata $Y_i$; and perform data compression on the second location indication information and the second element sequence, to obtain second compressed data $Z_i''$ of the $i^{th}$ piece of subdata $Y_i$, where the second compressed data $Z_i''$ is different from the first compressed data $Z_i'$.

In a possible implementation, the second location indication information is a second bitmap, bits in the second bitmap one-to-one correspond to second elements in the sparse matrix $X_i$, and the bits in the second bitmap indicate whether the corresponding second elements in the sparse matrix $X_i$ have the first capability of expressing the $i^{th}$ piece of subdata $Y_i$.

In a possible implementation, the processing module is further configured to: determine third location indication information and a third element sequence that are of the sparse matrix $X_i$, where the third location indication information indicates whether an element in the sparse matrix $X_i$ has a second capability of expressing the $i^{th}$ piece of subdata $Y_i$, and the third element sequence includes an element that has the second capability of expressing the $i^{th}$ piece of subdata $Y_i$; and perform data compression on the third location indication information and the third element sequence that are of the sparse matrix $X_i$, to obtain third compressed data $Z_i'''$ of the $i^{th}$ piece of subdata $Y_i$; and the transceiver module is further configured to send the third compressed data $Z_i'''$ to the second communication apparatus.

In a possible implementation, the third location indication information is a third bitmap, bits in the third bitmap one-to-one correspond to the elements in the sparse matrix $X_i$, and the bits in the third bitmap indicate whether the corresponding elements in the sparse matrix $X_i$ have the second capability of expressing the $i^{th}$ piece of subdata $Y_i$.

In a possible implementation, the processing module is specifically configured to: determine whether each element in the sparse matrix $X_i$ has the second capability of expressing the $i^{th}$ piece of subdata $Y_i$ based on the element, the first capability threshold, and a second capability threshold; and determine the third location indication information and the third element sequence based on whether each element in the sparse matrix $X_i$ has the second capability of expressing the $i^{th}$ piece of subdata $Y_i$.

In a possible implementation, the processing module is further configured to determine a third element sequence of the sparse matrix $X_i$, where the third element sequence includes N elements in the sparse matrix $X_i$ other than an element included in the first element sequence, and N is a positive integer; the processing module is further configured to perform data compression on the third element sequence, to obtain third compressed data $Z_i'''$ of the $i^{th}$ piece of subdata $Y_i$; and the transceiver module is further configured to send the third compressed data $Z_i''$ to the second communication apparatus.

In a possible implementation, the N elements are elements in preset rows/columns in a sparse matrix $X_i$.

In a possible implementation, quantities of columns of matrices formed by the M pieces of subdata are the same.

In a possible implementation, the first data includes point cloud data, and the M pieces of subdata are obtained by splitting the first data based on distances between spatial points in the first data in Euclidean space; or the first data includes artificial intelligence AI model data, and the M pieces of subdata are obtained by splitting the first data based on neural network layers at which pieces of data in the first data are located.

In a possible implementation, the first data includes the point cloud data, the processing module is further configured to: perform, by using cubes with a preset side length, spatial division on Euclidean space in which initial point cloud data is located, and use a geometric center of spatial points in a cube as a sampling point of the cube; and the processing unit is further configured to determine the first data based on sampling points of the cubes.

In a possible implementation, the transceiver module is further configured to send an upload request to the second communication apparatus, where the upload request carries first indication information, and the first indication information indicates a data type of the first data.

In a possible implementation, the data type includes point cloud data or AI model data.

In a possible implementation, the transceiver module is further configured to receive resource configuration information sent by the second communication apparatus, where the resource configuration information indicates a time-frequency resource of the compressed data of the M pieces of subdata; and the transceiver module is further configured to send the compressed data on the first time-frequency resource.

In a possible implementation, the processing module is further configured to determine a compression parameter based on the time-frequency resource of the first data; and the processing module is further configured to perform data compression on the $i^{th}$ piece of subdata $Y_i$ based on the compression parameter, to obtain the compressed data $Z_i$, where the compression parameter includes at least one of the following:

the first capability threshold, where the first capability threshold is used to determine whether an element in the sparse matrix $X_i$ has the first capability of expressing the $i^{th}$ piece of subdata $Y_i$;
the second capability threshold, where the second capability threshold is used to determine whether an element in the sparse matrix $X_i$ has the second capability of expressing the $i^{th}$ piece of subdata $Y_i$;
a coding scheme parameter;
a quantization precision parameter; and
a quantity of columns of subdata.

In a possible implementation, the transceiver module is further configured to send second indication information to the second communication apparatus, where the second indication information indicates at least one of the following:

the first capability threshold, where the first capability threshold is used to determine whether an element in the sparse matrix $X_i$ has the first capability of expressing the $i^{th}$ piece of subdata $Y_i$;

the second capability threshold, where the second capability threshold is used to determine whether an element in the sparse matrix $X_i$ has the second capability of expressing the $i^{th}$ piece of subdata $Y_i$;

a proportion of elements that are in the sparse matrix $X_i$ and that have the first capability of expressing the $i^{th}$ piece of subdata $Y_i$;

a data loss of the compressed data $Z_i$ relative to the $i^{th}$ piece of subdata $Y_i$;

a coding scheme parameter;

a quantization precision parameter;

a quantity of columns of subdata; and

whether location indication information of the sparse matrix $X_i$ is differentiated location indication information.

For beneficial effects of the communication apparatus provided in the third aspect and the possible implementations of the third aspect, refer to beneficial effects brought by the first aspect, the second aspect, or the possible implementations of the first aspect and the second aspect. Details are not described herein again.

According to a fourth aspect, an embodiment of this application provides a communication apparatus, including: a transceiver module, configured to receive compressed data $Z_i$ of an $i^{th}$ piece of subdata $Y_i$ in M pieces of subdata sent by a first communication apparatus, where the M pieces of subdata are included in first data, M is an integer greater than or equal to 1, and i is an integer greater than or equal to 1 and less than or equal to M; and a processing module, configured to: determine a dictionary matrix $D_i'$ and a sparse matrix $X_i'$ based on the compressed data $Z_i$, where the dictionary matrix $D_i'$ includes a feature of the $i^{th}$ piece of subdata $Y_i$, and the sparse matrix $X_i'$ is used to express the $i^{th}$ piece of subdata $Y_i$ based on the dictionary matrix $D_i'$; and construct an $i^{th}$ piece of subdata $Y_i'$ in M pieces of subdata of second data based on the dictionary matrix $D_i'$ and the sparse matrix $X_i'$.

In a possible implementation, the compressed data $Z_i$ includes first compressed data $Z_i'$, and the processing module is specifically configured to: decompress the first compressed data $Z_i'$ to obtain the dictionary matrix $D_i'$, and first location indication information and a first element sequence that are of the sparse matrix $X_i'$, where the first location indication information indicates whether an element in the sparse matrix $X_i'$ has a first capability of expressing the $i^{th}$ piece of subdata $Y_i$ in the M pieces of subdata of the first data, and the first element sequence includes an element that has the first capability of expressing the $i^{th}$ piece of subdata $Y_i$; or the first location indication information indicates whether a first element in the sparse matrix $X_i'$ has a first capability of expressing the $i^{th}$ piece of subdata $Y_i$, elements in the sparse matrix $X_i'$ include the first element, and the first element sequence includes a first element that has the first capability of expressing the $i^{th}$ piece of subdata $Y_i$; and determine the sparse matrix $X_i'$ based on the first location indication information and the first element sequence that are of the sparse matrix $X_i'$.

In a possible implementation, the first location information is a first bitmap; and bits in the first bitmap one-to-one correspond to the elements in the sparse matrix $X_i'$, and a bit in the first bitmap indicates whether a corresponding element in the sparse matrix $X_i'$ has the first capability of expressing the $i^{th}$ piece of subdata $Y_i$; or bits in the first bitmap one-to-one correspond to first elements in the sparse matrix $X_i'$, and a bit in the first bitmap indicates whether a corresponding first element in the sparse matrix $X_i'$ has the first capability of expressing the $i^{th}$ piece of subdata $Y_i$.

In a possible implementation, the first location indication information of the sparse matrix $X_i'$ is differentiated location indication information obtained by performing exclusive OR on first location indication information of the $i^{th}$ piece of subdata and first location indication information of an $(i-1)^{th}$ piece of subdata.

In a possible implementation, the compressed data $Z_i$ further includes second compressed data $Z_i''$, and the first location indication information indicates whether the first element in the sparse matrix $X_i'$ has the first capability of expressing the $i^{th}$ piece of subdata $Y_i$; and the processing module is specifically configured to: decompress the second compressed data $Z_i''$, to obtain second location indication information and a second element sequence that are of the sparse matrix $X_i'$, where the second location indication information indicates whether a second element in the sparse matrix $X_i'$ has the first capability of expressing the $i^{th}$ piece of subdata $Y_i$, and the second element sequence includes a second element that has the first capability of expressing the $i^{th}$ piece of subdata $Y_i$; and determine the sparse matrix $X_i'$ based on the first location indication information, the first element sequence, the second location indication information, and the second element sequence that are of the sparse matrix $X_i'$.

In a possible implementation, the second location indication information is a second bitmap, bits in the second bitmap one-to-one correspond to second elements in the sparse matrix $X_i'$, and the bits in the second bitmap indicate whether the corresponding second elements in the sparse matrix $X_i'$ have the first capability of expressing the $i^{th}$ piece of subdata $Y_i$.

In a possible implementation, the compressed data $Z_i$ further includes third compressed data $Z_i'''$; and the processing module is specifically configured to: decompress the third compressed data $Z_i'''$, to obtain third location indication information and a third element sequence that are of the sparse matrix $X_i'$, where the third location indication information indicates whether an element in the sparse matrix $X_i'$ has a second capability of expressing the $i^{th}$ piece of

subdata $Y_i$, and the second element sequence includes an element that has the second capability of expressing the $i^{th}$ piece of subdata $Y_i$; and determine the sparse matrix $X_i'$ based on the third location indication information and the third element sequence that are of the sparse matrix $X_i'$, and at least one of the following:

the first location indication information and the first element sequence that are of the sparse matrix $X_i'$; and
the second location indication information and the second element sequence that are of the sparse matrix $X_i'$.

In a possible implementation, the third location indication information is a third bitmap, bits in the third bitmap one-to-one correspond to the elements in the sparse matrix $X_i'$, and the bits in the third bitmap indicate whether the corresponding elements in the sparse matrix $X_i'$ have the second capability of expressing the $i^{th}$ piece of subdata $Y_i$.

In a possible implementation, the compressed data $Z_i$ further includes third compressed data $Z_i'''$; and the processing module is specifically configured to: decompress the third compressed data $Z_i'''$, to obtain a third element sequence of the sparse matrix $Xi'$, where the third element sequence includes N elements in the sparse matrix $X_i'$ other than elements included in the first element sequence and/or the second element sequence, and N is a positive integer; and determine the sparse matrix $X_i'$ based on the third element sequence of the sparse matrix $X_i'$ and at least one of the following:

the first location indication information and the first element sequence that are of the sparse matrix $X_i'$; and
the second location indication information and the second element sequence that are of the sparse matrix $X_i'$.

In a possible implementation, the N elements are elements in preset rows/columns in a sparse matrix $X_i$.

In a possible implementation, quantities of columns of matrices formed by the M pieces of subdata are the same.

In a possible implementation, the first data includes point cloud data, and the M pieces of subdata are obtained by splitting the first data based on distances between spatial points in the first data in Euclidean space; or the first data includes artificial intelligence AI model data, and the M pieces of subdata are obtained by splitting the first data based on neural network layers at which pieces of data in the first data are located.

In a possible implementation, the transceiver unit is further configured to receive an upload request sent by the first communication apparatus, where the upload request carries first indication information, and the first indication information indicates a data type of the first data.

In a possible implementation, the data type includes point cloud data or AI model data.

In a possible implementation, the transceiver module is further configured to: send resource configuration information to the first communication apparatus, where the resource configuration information indicates a time-frequency resource of the compressed data of the M pieces of subdata; and receive the compressed data $Z_i$ on the time-frequency resource.

In a possible implementation, the transceiver module is further configured to receive second indication information sent by the first communication apparatus, where the second indication information indicates at least one of the following:

the first capability threshold, where the first capability threshold is used to determine whether an element in the sparse matrix $X_i$ has the first capability of expressing the $i^{th}$ piece of subdata $Y_i$;
the second capability threshold, where the second capability threshold is used to determine whether an element in the sparse matrix $X_i$ has the second capability of expressing the $i^{th}$ piece of subdata $Y_i$;
a proportion of elements that are in the sparse matrix $X_i$ and that have the first capability of expressing the $i^{th}$ piece of subdata $Y_i$;
a data loss of the compressed data $Z_i$ relative to the $i^{th}$ piece of subdata $Y_i$ in the M pieces of subdata of the first data;
a coding scheme parameter;
a quantization precision parameter;
a quantity of columns of subdata; and
whether a bitmap of the sparse matrix $X_i$ is a differentiated bitmap.

In a possible implementation, the second data is point cloud data, and the processing module is further configured to: when a distance between two adjacent spatial points of the second data in Euclidean space is greater than or equal to a second distance threshold, perform interpolation between the two adjacent spatial points.

In a possible implementation, the processing module is specifically configured to: add a spatial point at an intersection point of a connection line between the two adjacent spatial points and a sideline of a circle, where the circle uses one of the two adjacent spatial points as a center of the circle, and uses a third distance threshold as a radius in the Euclidean space.

For beneficial effects of the communication apparatus provided in the fourth aspect and the possible implementations of the fourth aspect, refer to beneficial effects brought by the first aspect, the second aspect, or the possible implementations of the first aspect and the second aspect. Details are not described herein again.

According to a fifth aspect, an embodiment of this application provides a communication apparatus, including a processor, configured to perform, by running a computer program or by using a logic circuit, the method in the first aspect, the second aspect, or the possible implementations.

In a possible implementation, the communication apparatus further includes a memory, and the memory is configured to store the computer program.

In a possible implementation, the communication apparatus further includes a communication interface, and the communication interface is configured to input and/or output a signal.

According to a sixth aspect, an embodiment of this application provides a communication system, including a first communication apparatus configured to perform the method in the first aspect or the possible implementations, and a second communication apparatus configured to perform the method in the second aspect or the possible implementations.

According to a seventh aspect, an embodiment of this application provides a computer-readable storage medium, configured to store computer program instructions, where the computer program instructions enable a computer to perform the method in the first aspect, the second aspect, or the possible implementations.

According to an eighth aspect, an embodiment of this application provides a computer program product, including computer program instructions, where the computer program instructions enable a computer to perform the method in the first aspect, the second aspect, or the possible implementations.

According to a ninth aspect, an embodiment of this application provides a computer program, where the computer program enables a computer to perform the method in the first aspect, the second aspect, or the possible implementations.

**BRIEF DESCRIPTION OF DRAWINGS**

FIG. 1 is a diagram of an architecture of a mobile communication system to which an embodiment of this application is applied;
FIG. 2 is a diagram of a dictionary learning framework according to an embodiment of this application;
FIG. 3 is a schematic interaction flowchart of a data compression and transmission method according to an embodiment of this application;
FIG. 4 is a schematic flowchart of data compression and transmission according to an embodiment of this application;
FIG. 5 is a diagram of data split according to an embodiment of this application;
FIG. 6 is a diagram of a dictionary learning-based data compression method according to an embodiment of this application;
FIG. 7 is a diagram of a dictionary learning-based data compression method according to an embodiment of this application;
FIG. 8 is a diagram of a dictionary learning-based data compression method according to an embodiment of this application;
FIG. 9 is a diagram of a dictionary learning-based data compression method according to an embodiment of this application;
FIG. 10 is a diagram of a dictionary learning-based data compression method according to an embodiment of this application;
FIG. 11 is a diagram of a dictionary learning-based data compression method according to an embodiment of this application;
FIG. 12 is a diagram of a time domain resource for incremental transmission according to an embodiment of this application;
FIG. 13 is a diagram of differentiated location indication information according to an embodiment of this application;
FIG. 14 is a diagram of a sampling process at a layer according to an embodiment of this application;
FIG. 15 is a diagram of a sampling process at another layer according to an embodiment of this application;
FIG. 16 is a diagram of an interpolation process according to an embodiment of this application;
FIG. 17 is a schematic interaction flowchart of another data compression and transmission method according to an embodiment of this application;
FIG. 18 is a block diagram of a communication apparatus according to an embodiment of this application; and
FIG. 19 is another block diagram of a communication apparatus according to an embodiment of this application.

## DESCRIPTION OF EMBODIMENTS

The following describes technical solutions of this application with reference to accompanying drawings.

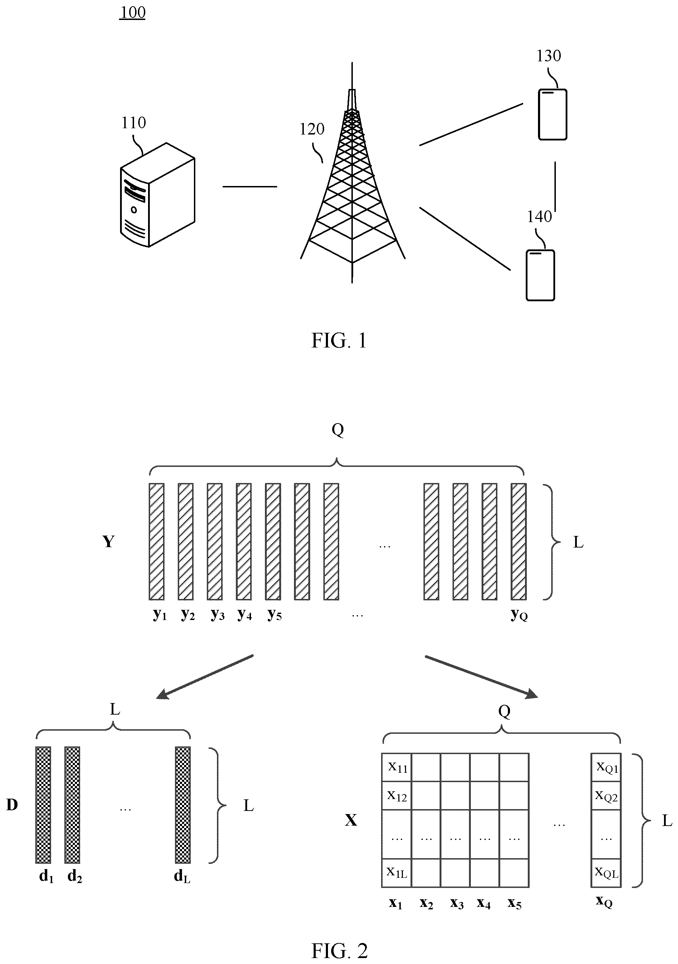

FIG. 1 is a diagram of an architecture of a mobile communication system to which embodiments of this application are applied. As shown in FIG. 1, the mobile communication system includes a core network device 110, a network device 120, and at least one terminal device (for example, a terminal device 130 and a terminal device 140 in FIG. 1). The terminal device is connected to the network device in a wireless manner, and the network device is connected to the core network device in a wireless or wired manner. The core network device and the network device may be different independent physical devices, functions of the core network device and logical functions of the network device may be integrated on a same physical device, or some functions of the core network device and some functions of the network device may be integrated on one physical device. The terminal device may be at a fixed location, or may be mobile. FIG. 1 is merely a diagram. The communication system may further include other network devices, for example, a wireless relay device and a wireless backhaul device, which are not drawn in FIG. 1. Quantities of core network devices, network devices, and terminal devices included in the mobile communication system are not limited in embodiments of this application.

In embodiments of this application, a network device may be any device having a wireless transceiver function. The network device includes but is not limited to: an evolved NodeB (evolved NodeB, eNB), a home NodeB (for example, a home evolved NodeB, or a home NodeB, HNB), a baseband unit (baseband unit, BBU), an access point (access point, AP) in a wireless fidelity (wireless fidelity, Wi-Fi) system, a wireless relay node, a wireless backhaul node, a transmission point (transmission point, TP), or a transmission and reception point (transmission and reception point, TRP), may be a mobile switching center, a device that undertakes functions of a base station in device-to-device (Device-to-Device, D2D), vehicle-to-everything (vehicle-to-everything, V2X), machine-to-machine (machine-to-machine, M2M) communication, and unmanned aerial vehicle communication, and a network device (which may be deployed on a high-altitude platform, a satellite, or a high-altitude aircraft) in a non-terrestrial network (non-terrestrial network, NTN) communication system, may be a gNB in a 5G system or one or a group of antenna panels (including a plurality of antenna panels) of a base station in a 5G system, or may be a network node that forms a gNB or a transmission point, for example, a BBU or a distributed unit (distributed unit, DU). This is not specifically limited in embodiments of this application.

In some deployments, the gNB may include a central unit (central unit, CU) and a DU. The CU and the DU each implement some functions of the gNB, and the CU and the DU may communicate with each other through an F1 interface. The gNB may further include an active antenna unit (active antenna unit, AAU). The AAU may implement some physical layer processing functions, radio frequency processing, and a function related to an active antenna.

It may be understood that the network device may be a device including one or more of a CU node, a DU node, and an AAU node. In addition, the CU may be classified into a network device in an access network (radio access network, RAN), or the CU may be classified into a network device in a core network (core network, CN). This is not limited in this application.

In embodiments of this application, a terminal device may also be referred to as user equipment (user equipment, UE), an access terminal, a subscriber unit, a subscriber station, a mobile station, a mobile console, a remote station, a remote terminal, a mobile device, a user terminal, a terminal, a wireless communication device, a user agent, or a user apparatus.

The terminal device may be a device that provides voice/data connectivity for a user, for example, a handheld device or a vehicle-mounted device that has a wireless connection function. Currently, the terminal may be, for example, a mobile phone (mobile phone), a tablet computer (pad), a computer with a wireless transceiver function (such as a notebook computer or a palmtop computer), an unmanned aerial vehicle, customer-premises equipment (customer-premises equipment, CPE), a point of sale (point of sale, POS) machine, a mobile internet device (mobile internet device, MID), a virtual reality (virtual reality, VR) device, an augmented reality (augmented reality, AR) device, a wireless terminal in industrial control (industrial control), a wireless terminal in self-driving (self driving), a wireless terminal in telemedicine (remote medical), a wireless terminal in a smart grid (smart grid), a wireless terminal in transportation safety (transportation safety), a wireless terminal in a smart city (smart city), a wireless terminal in a smart home (smart home), a cellular phone, a cordless phone, a session initiation protocol (session initiation protocol, SIP) phone, a wireless local loop (wireless local loop, WLL) station, a personal digital assistant (personal digital assistant, PDA), a handheld device with a wireless communication function, a computing device, another processing device connected to a wireless modem, a vehicle-mounted device, a wearable device, a terminal device in a 5G network, a terminal device in a system evolved after 5G, or the like.

The network device and the terminal device may communicate with each other through a licensed spectrum (licensed spectrum), an unlicensed spectrum (unlicensed spectrum), or both a licensed spectrum and an unlicensed spectrum. The network device and the terminal device may communicate with each other through a spectrum below 6G, a spectrum above 6G, or both a spectrum below 6G and a spectrum above 6G. A spectrum resource used between the network device and the terminal device is not limited in embodiments of this application.

It should be understood that specific forms of the network device and the terminal device are not limited in this application.

The communication method provided in this application may be applied to various communication systems, for example, a long term evolution (Long Term Evolution, LTE) system, a 5G mobile communication system, and a mobile communication system evolved after 5G such as 6G. The 5G mobile communication system or the 6G mobile communication system may include non-standalone (non-standalone, NSA) networking and/or standalone (standalone, SA) networking.

The communication method provided in this application may be further applied to machine type communication (machine type communication, MTC), a machine-to-machine communication long term evolution (Long Term Evolution-machine, LTE-M) technology, a device-to-device (device to device, D2D) network, a machine-to-machine (machine to machine, M2M) network, an internet of things (internet of things, IoT) network, or other networks.

Point cloud data (point cloud data) is a set of spatial points in a three-dimensional coordinate system. For example, data is collected by using a machine vision sensor and recorded in a form of a point, and each spatial point includes three-dimensional coordinates, and may include color information (RGB), location information, reflection intensity (intensity) information, and the like. In a point cloud scenario, a terminal device (for example, 130 and/or 140 in FIG. 1) may collect data by using a sensor, and transmit the collected data to a network device (for example, 120 in FIG. 1), and the network device (for example, 120 in FIG. 1) may reconstruct point cloud data.

Federated learning (federated learning) is a distributed machine learning technology that performs distributed model training between a plurality of data sources that have local data, and builds a global model based on virtual converged data by exchanging only model parameters or intermediate results without exchanging local individuals or sample data, to balance data privacy protection and data sharing and computing. A model parameter, an AI gradient, or an intermediate result transmitted in a federated learning process may be referred to as AI model data. Certainly, the AI model data is merely a possible name, and a name is not limited in this application. For example, the AI model data may also be referred to as model data or AI data. In a federated learning scenario, a terminal device (for example, 130 and/or 140 in FIG. 1) may transmit locally updated AI model data to a network device (for example, 120 in FIG. 1), to update global AI model data.

A data amount of the point cloud data and a data amount of the AI model data are large. Generally, the point cloud data may include hundreds of thousands of spatial points, and the AI model data may reach an order of magnitude of tens of millions of dimensions.

Currently, there is no effective and reliable compression and transmission solution for communication scenarios in which a large amount of data is transmitted, for example, the point cloud scenario and the federated learning scenario. To implement effective and reliable data compression and transmission, in embodiments of this application, to-be-transmitted data is split into a plurality of pieces of subdata, at least one piece of subdata is converted based on dictionary learning, and then data compression is performed on the converted data. In this way, effective and reliable data compression is performed on the to-be-transmitted data with a large data amount.

It should be noted that the foregoing examples are described only by using uplink transmission of the point cloud data and the AI model data as examples, but should not be construed as any limitation on this application. For example, in the point cloud scenario, a terminal device A (for example, 130 in FIG. 1) may send point cloud data to a terminal device B (for example, 140 in FIG. 1) through forwarding by a network device (for example, 120 in FIG. 1); or the terminal device A may send the point cloud data to the terminal device B through a sidelink. For another example, in the federated learning scenario, a network device (for example, 120 in FIG. 1) may transmit locally updated AI model data to a terminal device (for example, 130 and/or 140 in FIG. 1).

For ease of understanding of this application, dictionary learning is first described by using an example.

FIG. 2 is a diagram of a dictionary learning framework according to an embodiment of this application. As shown in FIG. 2, source data (source data) Y may be represented by a matrix of L rows multiplied by Q columns, and may also be referred to as a source matrix, and the source data Y is decomposed into a dictionary (dictionary) matrix D and a sparse matrix (sparse code) X through a numerical iteration process of dictionary learning, that is, Y=DX. Each element in a matrix representation of the source data Y may be a floating-point number.

The dictionary matrix D, which is also referred to as a base (base), may be a matrix of L rows multiplied by L columns, and each column in the dictionary matrix D may be referred to as a base (base) vector. The dictionary matrix D includes a feature of the source data. For example, the feature of the source data is expressed through base vectors.

The sparse matrix X may express the source data based on the dictionary matrix D. The sparse matrix X uses combinations, for example, obtained by weighting and then combining the base vectors in the dictionary matrix D, of the base vectors in the dictionary matrix D to express the feature of the source data. The sparse matrix X is a matrix of L rows multiplied by Q columns. Each column vector in the sparse matrix X may represent each column vector in the source matrix Y. For example, a first column vector $I_1$ in the sparse matrix X may represent $y_1$ in the source matrix.

Each row vector in the sparse matrix X corresponds to each base vector in the dictionary matrix D, and a value of each row in a column in the sparse matrix X represents a weight of each base vector in the dictionary matrix D. For example, a first column vector $x_1$ in the sparse matrix X is used to express $y_1$ in the source data Y, and elements in rows in the first column vector in the sparse matrix X are sequentially $x_{11}$, $x_{12}$, ..., and $x_{1L}$. In this case, $x_{11}$ is a weight of a first base vector $d_1$ in the dictionary matrix used when the source matrix Y is expressed by using the sparse matrix X.

An element in the sparse matrix X may be represented or stored in a coordinate format (coordinate format), and each element may include values of a row, a column, and the element in the sparse matrix X. Therefore, the element in the sparse matrix X may also be referred to as a coordinate (coordinate).

A larger quantity of elements whose values are 0 in the sparse matrix X indicates that less resources are occupied by information that has a low correlation with a learning task, so that storage resource overheads and transmission resource overheads are reduced while the sparse matrix X has a good capability of expressing the source data Y. In this case, it is considered that sparse performance of the sparse matrix X is good.

The following describes the communication method provided in embodiments of this application with reference to the accompanying drawings.

It should be understood that, merely for ease of understanding and description, the following describes the method provided in embodiments of this application by using interaction between a first communication apparatus and a second communication apparatus as an example. When the data compression and transmission method provided in embodiments of this application is applied to uplink transmission, the first communication apparatus may be any terminal device in the communication system shown in FIG. 1, for example, the terminal device 130 or the terminal device 140, and the second communication apparatus may be the network device 120 in the communication system shown in FIG. 1. When the data compression and transmission method provided in embodiments of this application is applied to downlink transmission, the first communication apparatus may be the network device 120 in the communication system shown in FIG. 1, and the second communication apparatus may be any terminal device in the communication system shown in FIG. 1, for example, the terminal device 130 or the terminal device 140. When the data compression and transmission method provided in embodiments of this application is applied to sidelink transmission, the first communication apparatus may be any terminal device in the communication system shown in FIG. 1, for example, the terminal device 130, and the second communication apparatus may be any terminal device other than the first communication apparatus in the communication system shown in FIG. 1, for example, the terminal device 140.

It should be further understood that this should not constitute any limitation on an execution body of the method provided in this application. Any device that can perform the method provided in embodiments of this application by running a program that has code of the method provided in embodiments of this application may execute the method provided in embodiments of this application. For example, any one of the foregoing communication apparatuses may be implemented as a terminal device, or a component in a terminal device, for example, a chip, a chip system, or another functional module that can invoke and execute a program. Alternatively, any one of the foregoing communication apparatuses may be implemented as a network device, or a component in a network device, for example, a chip, a chip system, or another functional module that can invoke and execute a program.

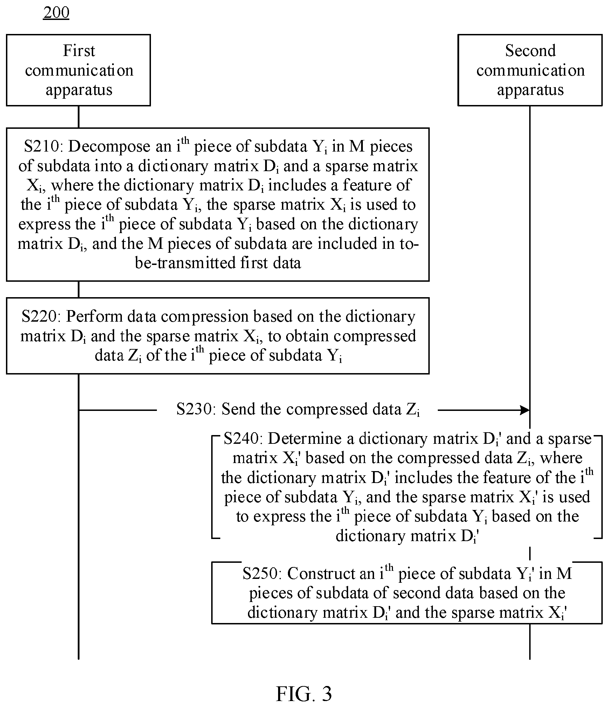

FIG. 3 is a schematic interaction flowchart of a data compression and transmission method according to an embodiment of this application. With reference to FIG. 3, a method 200 includes a part of or the entire process:

S210: The first communication apparatus decomposes an $i^{th}$ piece of subdata $Y_i$ in M pieces of subdata into a dictionary matrix $D_i$ and a sparse matrix $X_i$, where the dictionary matrix $D_i$ includes a feature of the $i^{th}$ piece of subdata $Y_i$, the sparse matrix $X_i$ is used to express the $i^{th}$ piece of subdata $Y_i$ based on the dictionary matrix $D_i$, the M pieces of subdata are included in to-be-transmitted first data, M is an integer greater than or equal to 1, and i is an integer greater than or equal to 1 and less than or equal to M.

S220: The first communication apparatus performs data compression based on the dictionary matrix $D_i$ and the sparse matrix $X_i$, to obtain compressed data $Z_i$ of the $i^{th}$ piece of subdata $Y_i$.

S230: The first communication apparatus sends the compressed data $Z_i$ to the second communication apparatus. Correspondingly, the second communication apparatus receives the compressed data $Z_i$ of the $i^{th}$ piece of subdata $Y_i$ in the M pieces of subdata sent by the first communication apparatus.

S240: The second communication apparatus determines a dictionary matrix $D_i'$ and a sparse matrix $X_i'$ based on the compressed data $Z_i$, where the dictionary matrix $D_i'$ includes the feature of the $i^{th}$ piece of subdata $Y_i$, and the sparse matrix $X_i'$ is used to express the $i^{th}$ piece of subdata $Y_i$ based on the dictionary matrix $D_i'$.

S250: The second communication apparatus constructs an $i^{th}$ piece of subdata $Y_i'$ in M pieces of subdata of second data based on the dictionary matrix $D_i'$ and the sparse matrix $X_i'$.

In this embodiment of this application, constructing the second data may alternatively be expressed as restoring the first data to obtain the second data. In addition, for ease of description, meanings expressed after the word order is changed are also consistent. For example, the foregoing description may alternatively be replaced with performing construction for the second data or restoring the first data.

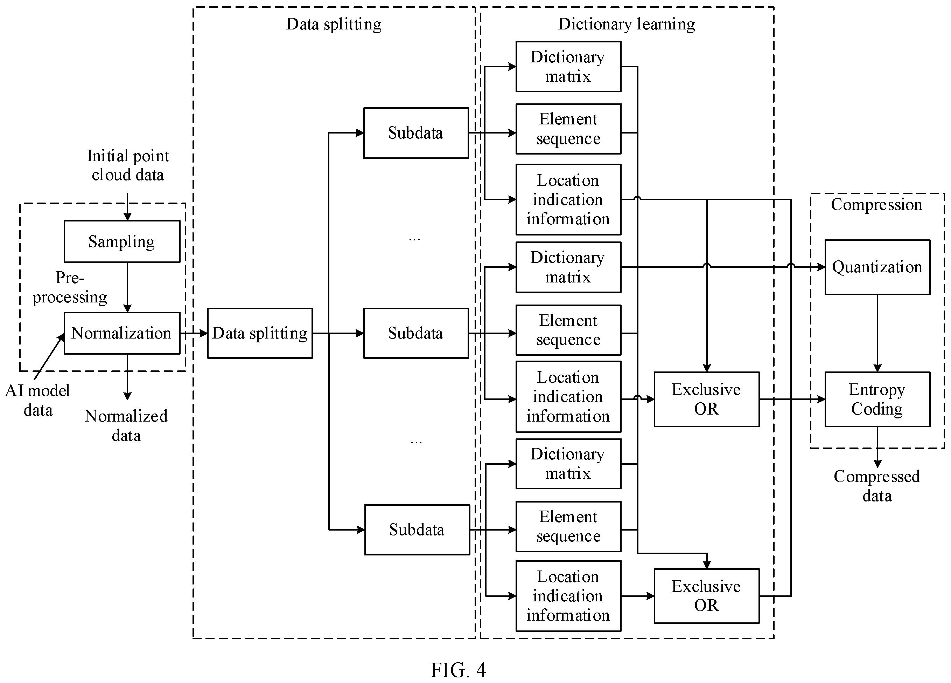

First, it should be noted that if the to-be-transmitted first data is used as the source data Y, and data compression is performed on the to-be-transmitted first data based on dictionary learning, when a data amount of the first data is large, the source data Y is widely distributed in space, and it is difficult to determine the dictionary matrix to obtain a sparse matrix with good sparsity. Consequently, a data processing process of obtaining the dictionary matrix D and the sparse matrix X through decomposition is complex, and a delay is long. In view of this, in this embodiment of this application, the first communication apparatus may split the first data into the M pieces of subdata, referring to a data splitting process in FIG. 4, and then perform dictionary learning on each piece of subdata.

The first data may be a matrix. In other words, the first data is expressed in a form of a matrix. The first communication apparatus may arrange the first data into a matrix Y of L rows multiplied by Q columns. For example, when the first data is point cloud data, L is equal to a dimension of spatial points, that is, L=3, and Q is equal to a total quantity of spatial points in the point cloud data. For another example, when the first data is AI model data, L may be a preset value, for example, may be a value that is obtained through an experiment and that allows the sparse matrix to have better sparse performance, and $N = \left\lceil \dfrac{Dim}{L} \right\rceil$, where $\lceil \cdot \rceil$ represents rounding up, and *Dim* is a gradient dimension. In this case, *LQ-Dim* 0s need to be added to the first data Y.

The first communication apparatus may split the first data into the M pieces of subdata, for example, split the first data into the M pieces of subdata based on a relationship between pieces of data in the first data in space. Each piece of subdata may be a matrix.

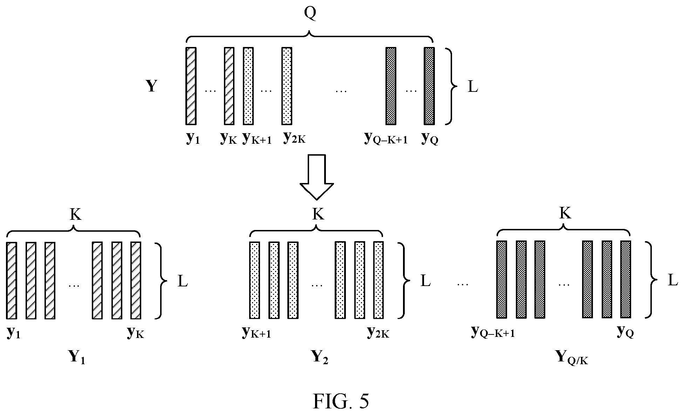

With reference to FIG. 5, Q columns (for example, $y_1$ to $y_Q$) in the first data Y may be split into the M pieces of subdata. For example, through splitting, $y_1$ to $y_K$ form a first piece of subdata $Y_1$, $y_{K+1}$ to $y_{2K}$ form a second piece of subdata $Y_2$, ..., and $y_{Q-K+1}$ to $y_Q$ form a third piece of subdata $Y_{Q/K}$. FIG. 5 is described only by using an example in which quantities of columns of matrices formed by the M pieces of subdata are the same. However, this is not limited in this application. For example, quantities of columns of matrices formed by at least two pieces of subdata in the M pieces of subdata are different. When the quantities of columns of the matrices formed by all of the subdata are the same, data processing complexity of the first communication apparatus and the second communication apparatus can be reduced.

For example, the first data is point cloud data. The first communication apparatus may split the first data into the M pieces of subdata based on distances between spatial points in the first data in Euclidean space. For example, P spatial points may be determined in ascending order of distances between the spatial points, where P is a preset value, and the P spatial points are grouped into one piece of subdata. Alternatively, spatial points in a preset range are classified into a sub-value. For example, spatial points in a circle whose center is a spatial point and whose radius is R are grouped into one piece of subdata, where R is a preset value.

For example, the first data is the AI model data. The first communication apparatus may split the first data into the M pieces of subdata based on neural network layers at which pieces of data in the first data are located. For example, data at a same neural network layer or a plurality of adjacent neural network layers is grouped into one piece of subdata. If a quantity of pieces of data at a same neural network layer exceeds a data amount limit for one piece of subdata, the data at the same neural network layer may be classified as two or more pieces of adjacent subdata. The neural network layer includes but is not limited to a fully connected layer, a convolutional layer, a pooling layer, and the like.

Optionally, refer to a preprocessing process in FIG. 4. The first communication apparatus may normalize first data Y" to obtain normalized first data Y. This can avoid an error caused by misidentifying some types of data as non-important data in a subsequent process of determining a sparse matrix based on dictionary learning due to numerical range differences between different types of data. For example, the first data is point cloud data. The first communication apparatus normalizes three-dimensional data of spatial points in the first data to a same numerical range, to avoid identifying data in a dimension as non-important data. For example, the first communication apparatus normalizes the first data Y" to obtain the first data Y, and uses a modulus value of each row in the first data Y" as normalized data, and the first communication apparatus may send the normalized data to the second communication apparatus, so that the second communication apparatus restores, based on the normalized data, the first data Y" before normalization.

It should be noted that the first communication apparatus performs data compression on the first data, and sends the compressed first data to the second communication apparatus, and the second communication apparatus performs data construction based on the compressed first data, to obtain the second data. Generally, the second data is different from the first data, and a smaller difference between the second data and the first data indicates better effect of data compression and data construction. Similar to the first data, the second data also includes M pieces of subdata, and the M pieces of subdata of the second data are respectively obtained by decompressing compressed data of the M pieces of subdata of the first data. In other words, the M pieces of subdata of the second data one-to-one correspond to the M pieces of subdata of the first data. The $i^{th}$ piece of subdata $Y_i'$ of the second data is constructed based on the compressed data of the $i^{th}$ piece of subdata $Y_i$ of the first data.

It should be further understood that, in a process in which the second communication apparatus performs data construction based on the compressed data $Z_i$, the dictionary matrix $D_i'$ and the sparse matrix $X_i'$ that are determined based on the compressed data $Z_i$ respectively correspond to the dictionary matrix $D_i$ and the sparse matrix $X_i$ that are determined by the first communication apparatus. Because a construction error may exist in a data construction process, the dictionary

matrix $D_i'$, the sparse matrix $X_i'$, the dictionary matrix $D_i$, and the sparse matrix $X_i$ are described in a differentiated manner. Various example descriptions of the dictionary matrix $D_i$ and the sparse matrix $X_i$ in the following may be used to explain the dictionary matrix $D_i'$ and the sparse matrix $X_i'$. Similarly, location indication information and element sequences described on a first communication apparatus side are also applicable in a data construction process on a second communication apparatus side.

It should be understood that the first communication apparatus may perform the compression process of S210 and S220 on all or some of the M pieces of subdata of the first data. If the first communication apparatus may perform the data compression process of S210 and S220 on some of the M pieces of subdata of the first data, data compression may be implemented on other subdata in the M pieces of subdata in any other compression manner. For example, data compression may be performed on an $(i+1)^{th}$ piece of subdata $Y_{i+1}$ through scalar quantization or vector quantization. Correspondingly, for subdata on which the data compression process of S210 and S220 have been performed, the second communication apparatus may perform a data construction process of S240 and S250 based on received compressed data corresponding to the subdata. The following describes S210 to S250 by using examples.

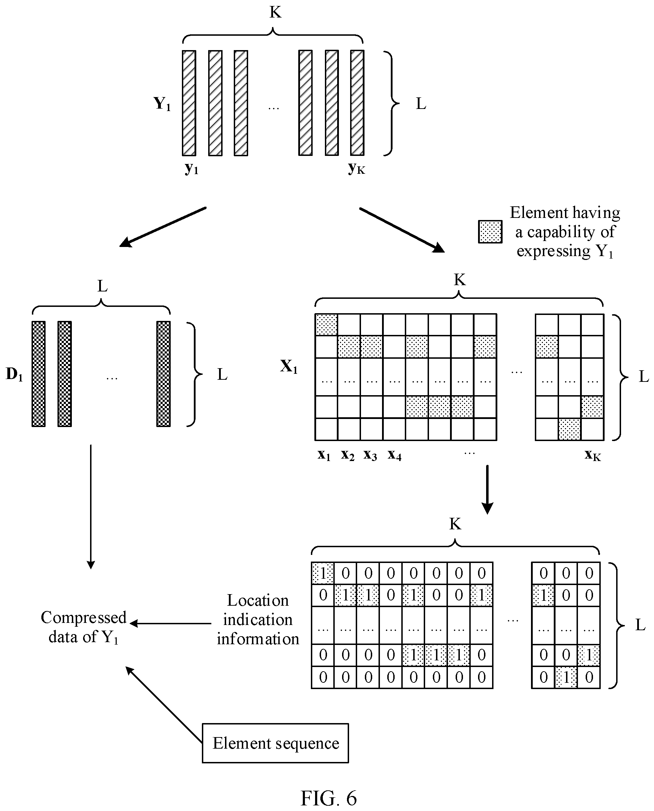

In S210, the first communication apparatus may decompose the $i^{th}$ piece of subdata $Y_i$ into the dictionary matrix $D_i$ and the sparse matrix $X_i$ based on dictionary learning. With reference to FIG. 6, a first piece of subdata $Y_1$ is used as an example. The first communication apparatus decomposes $Y_1$ to obtain a dictionary matrix $D_1$ and a sparse matrix $X_1$, the first piece of subdata $Y_1$ may be a matrix of L rows multiplied by K columns, the dictionary matrix $D_1$ obtained through decomposition may be a matrix of L rows multiplied by L columns, and the sparse matrix $X_1$ may be a matrix of L rows multiplied by K columns. However, in this application, a quantity of rows of the dictionary matrix and a quantity of columns of the dictionary matrix are not limited to be consistent with a quantity of rows of the first piece of subdata $Y_1$, that is, $D_1$ may include more or fewer elements.

In a possible implementation, a quantity of rows of the sparse matrix $X_1$ is consistent with a quantity of columns of the dictionary matrix $D_1$, and a quantity of columns of the sparse matrix $X_1$ is consistent with a quantity of columns of the first piece of subdata $Y_1$, that is, as described above, column vectors in the sparse matrix $X_1$ one-to-one correspond to column vectors in the first piece of subdata $Y_1$, values of row elements of the column vectors in the sparse matrix $X_1$ are weights of column vectors in the dictionary matrix $D_1$, and column vectors in the sparse matrix $X_1$ are used to represent the column vectors corresponding to the first piece of subdata $Y_1$ based on the column vectors in the dictionary matrix $D_1$ and the weights. However, this is not limited in this application. For example, a column vector in the sparse matrix $X_1$ may be used to express an element corresponding to the first piece of subdata $Y_1$.

In S220, the first communication apparatus may perform data compression on the dictionary matrix $D_i$ and the sparse matrix $X_i$, to obtain the compressed data $Z_i$ of the $i^{th}$ piece of subdata $Y_i$. Refer to a compression process in FIG. 4. The first communication apparatus may perform quantization (for example, scalar quantization or vector quantization) and/or entropy encoding on the dictionary matrix $D_i$ and the sparse matrix $X_i$, to obtain the compressed data $Z_i$ of the $i^{th}$ piece of subdata $Y_i$.

It should be understood that a sparse matrix $X_i$ with good sparse performance has a large quantity of elements whose values are 0, which implements compression on the first data to some extent. To further improve compression performance, in embodiments of this application, the sparse matrix $X_i$ is further processed to obtain location indication information and an element sequence shown in FIG. 6. The location indication information indicates whether an element in the sparse matrix $X_i$ has a capability of expressing the $i^{th}$ piece of subdata $Y_i$, and the element sequence includes an element that has the capability of expressing the $i^{th}$ piece of subdata $Y_i$. With reference to FIG. 6, in the sparse matrix $X_i$, an element in a column $x_1$ and a row 1, an element in a column $x_2$ and a row 2, an element in a column $x_3$ and a row 2, and the like have the capability of expressing the $i^{th}$ piece of subdata $Y_i$. In this case, the element sequence includes elements that are in the sparse matrix $X_i$ and that have the capability of expressing the $i^{th}$ piece of subdata $Y_i$, for example, the element in the column $x_1$ and the row 1, the element in the column $x_2$ and the row 2, and the element in the column $x_3$ and the row 2. For example, in the sparse matrix $X_i$, a value of the element in the column $x_1$ and the row 1 is 0.1, a value of the element in the column $x_2$ and the row 2 column is -0.5, a value of the element in the column $x_3$ and the row 2 is 0.8, ..., and these elements have the capability of expressing the $i^{th}$ piece of subdata $Y_i$. In this case, the element sequence may be represented as [0.1, 0.5, 0.8...]. However, absolute values of values of elements (including an element whose value is 0 or an element whose difference between a value of the element and 0 is less than a preset threshold) at locations other than the foregoing locations in the sparse matrix $X_i$ are small, and the elements at these locations do not have the capability of expressing the $i^{th}$ piece of subdata $Y_i$. For example, in $X_i$, a value of an element in the column $x_1$ and a row 2 is -0.005, and a value of an element in the column $x_2$ and a row 1 is 0.0002. In addition, the location indication information indicates locations, in the sparse matrix $X_1$, of the elements that have the capability of expressing the $i^{th}$ piece of subdata $Y_i$. In other words, the location indication information indicates which locations at which elements in the sparse matrix $X_1$ have the capability of expressing the $i^{th}$ piece of subdata $Y_i$.

The location indication information may include a tree structure, a bitmap, a location index, and the like. This is not limited in this application. For example, the location indication information is a bitmap. With reference to FIG. 6, bits in the bitmap one-to-one correspond to elements in the sparse matrix $X_i$, and the bits in the bitmap indicate whether the corresponding elements in the sparse matrix $X_i$ have the first capability of expressing the $i^{th}$ piece of subdata $Y_i$. For example, when a bit in the bitmap is 1, it indicates that a corresponding element in the sparse matrix $X_i$ has the capability of expressing the $i^{th}$ piece of subdata $Y_i$; or when a bit in the bitmap is 0, it indicates that a corresponding element in the sparse matrix $X_i$ does not have the capability of expressing the $i^{th}$ piece of subdata $Y_i$. For another example, when a bit in the bitmap is 0, it indicates that a corresponding element in the sparse matrix $X_i$ has the capability of expressing the $i^{th}$ piece of subdata $Y_i$; or when a bit in the bitmap is 1, it indicates that a corresponding element in the sparse matrix $X_i$ does not have the capability of expressing the $i^{th}$ piece of subdata $Y_i$.

The location indication information may include at least one location index, and each location index may indicate a location, in the sparse matrix $X_i$, of an element that is in the sparse matrix $X_i$ and that has the capability of expressing the $i^{th}$ piece of subdata $Y_i$. For example, the location index indicates that elements having the capability of expressing the $i^{th}$ piece of subdata $Y_i$ is in a column 5 and a row 2 in the sparse matrix $X_i$.

When the location indication information includes a tree structure, a basic tree structure corresponding to the sparse matrix $X_i$ may be constructed, and some or all subnodes in the basic tree structure one-to-one correspond to elements in the sparse matrix $X_i$. For example, in a process of constructing the basic tree structure, multi-level interval division may be performed on a basic two-dimensional plane, each interval is used as a subnode of the basic tree structure, and a quantity of minimum intervals (that is, subnodes at a lowest layer in the basic tree structure) obtained through division is greater than or equal to a quantity of elements in the sparse matrix $X_i$. A size of the basic two-dimensional plane is not limited in this application. For example, in the process of constructing the basic tree structure, the basic tree structure is equally divided into four intervals by using two straight lines that are perpendicular to each other, and the four intervals respectively correspond to four subnodes of a root node in the basic tree structure. When each of the four intervals includes an element that has the capability of expressing the $i^{th}$ piece of subdata $Y_i$, a value of a subnode corresponding to the interval is a third value. When an interval does not include an element that has the capability of expressing the $i^{th}$ piece of subdata $Y_i$, a value of a subnode corresponding to the interval is a fourth value. Further, the interval is divided into four subintervals by using two straight lines that are perpendicular to each other, and the four subintervals respectively correspond to four subnodes at a lower level of a subnode corresponding to the interval in the basic tree structure. Similarly, when a subinterval includes an element that has the capability of expressing the $i^{th}$ piece of subdata $Y_i$, a value of a subnode corresponding to the subinterval in the basic tree structure is a third value. When a subinterval does not include an element that has the capability of expressing the $i^{th}$ piece of subdata $Y_i$, a value of a subnode corresponding to the subinterval in the basic tree structure is a fourth value. The rest can be deduced by analogy, and construction of the tree structure ends until a minimum interval is obtained. The third value may be 1, and the fourth value may be 0; the third value may be 0, and the fourth value may be 1; or the third value and the fourth value may be any two different values. This is not limited in this application.

For example, a size of the sparse matrix $X_i$ of point cloud data is $3 \times 16$. In a process of constructing a basic tree structure, the basic tree structure is equally divided into four intervals by using two straight lines that are perpendicular to each other, the four intervals respectively correspond to four subnodes of a root node in the tree structure, each interval is then equally divided into four subintervals, and the four subintervals in the interval correspond to four subnodes at a lower level of a subnode corresponding to the interval in the basic tree structure. The rest may be deduced by analogy, $16 \times 16$ minimum intervals are obtained through four times of interval division (or four times of recursion), and the basic tree structure of the sparse matrix $X_i$ is constructed. Some subnodes in the basic tree structure may one-to-one correspond to elements in the sparse matrix $X_i$. For example, subnodes that correspond to $3 \times 16$ minimum intervals in the upper left corner of a basic two-dimensional plane and that are in the basic tree structure respectively indicate $3 \times 16$ elements in the sparse matrix $X_i$. Optionally, the location indication information may be the basic tree structure, and values of nodes that are in the basic tree structure and that correspond to intervals that are in the basic tree structure and that do not include elements in the sparse matrix $X_i$ are all fourth values. Alternatively, a tree structure in the location indication information may include some subnodes in the basic tree structure, and the some subnodes are subnodes corresponding to intervals that are in the basic two-dimensional plane and that include elements in the sparse matrix $X_i$.

In the foregoing examples, a minimum interval obtained through division includes one element in the sparse matrix $X_i$. A case in which a minimum interval includes a plurality of elements in the sparse matrix $X_i$ or a plurality of minimum intervals correspond to one element in the sparse matrix $X_i$ is not excluded in this application. When the minimum interval includes one element, a location indicated by the location indication information is more accurate, so that data constructed by the second communication apparatus based on the location indication information is more accurate. When the minimum interval includes a plurality of elements, the location indication information occupies fewer transmission resources, thereby reducing resource overheads.

The foregoing example descriptions of the location indication information may be applicable to the following related embodiments, and implementations of the location indication information are the same or similar. For brevity, details are not described again.

In some embodiments, the first communication apparatus may determine whether each element in the sparse matrix $X_i$ has the capability of expressing the $i^{th}$ piece of subdata $Y_i$ based on the element and a capability threshold. For example, when an absolute value of a value of the element is greater than the capability threshold, the first communication apparatus determines that the element has the capability of expressing the $i^{th}$ piece of data $Y_i$; when an absolute value of a value of the element is less than the capability threshold, the first communication apparatus determines that the element does not have the capability of expressing the $i^{th}$ piece of subdata $Y_i$; or when an absolute value of a value of the element is equal to the capability threshold, the first communication apparatus may determine the element as an element that has or does not have the capability of expressing the $i^{th}$ piece of data $Y_i$. This is not limited in this application. Further, the first communication apparatus determines the location indication information and the element sequence based on whether each element in the sparse matrix $X_i$ has the capability of expressing the $i^{th}$ piece of subdata $Y_i$.

Following the foregoing examples, the first communication apparatus may perform data compression on the dictionary matrix $D_i$, and the location indication information and the element sequence that are of the sparse matrix $X_i$. For example, as shown in FIG. 4, the first communication apparatus performs quantization and entropy encoding on the dictionary matrix $D_i$ and the sparse matrix $X_i$, and performs entropy encoding on the location indication information, to obtain the compressed data $Z_i$ of the $i^{th}$ piece of subdata $Y_i$.

The capability threshold may be determined based on a compression requirement, and capability thresholds corresponding to different data compression rate requirements may be different. For example, a compression rate requirement may be determined based on a resource configuration sent by the second communication apparatus. A first capability threshold and a second capability threshold in the following are similar to the foregoing case. Details are not described again.

In S230, the first communication apparatus may send the compressed data $Z_i$ determined in any one of the foregoing examples to the second communication apparatus. Optionally, the first communication apparatus may separately send compressed data of each of the M pieces of subdata, for example, separately perform protocol encapsulation on the compressed data of each piece of subdata and then send the compressed data, or the first communication apparatus may send compressed data of the M pieces of subdata as a same piece of data, for example, may perform protocol encapsulation on the compressed data of all the subdata together and then send the compressed data. In some embodiments, if the first communication apparatus transmits the compressed first data in an incremental manner, the compressed data $Z_i$ may be compressed data of the $i^{th}$ piece of subdata $Y_i$ in an initial transmission phase; or the compressed data $Z_i$ may include compressed data of the $i^{th}$ piece of subdata $Y_i$ in an initial transmission phase and compressed data of the $i^{th}$ piece of subdata $Y_i$ an incremental transmission phase, and if the compressed data $Z_i$ may include the compressed data of the $i^{th}$ piece of subdata $Y_i$ in the initial transmission phase and the compressed data of the $i^{th}$ piece of subdata $Y_i$ in the incremental transmission phase, the first communication apparatus performs protocol encapsulation on the compressed data in the initial transmission phase and the incremental transmission phase and then sends the compressed data.

In S240, the second communication apparatus may decompress the compressed data $Z_i$ to obtain the dictionary matrix $D_i'$ and the sparse matrix $X_i'$. A decompression manner is related to a compression manner used by the first communication apparatus for the $i^{th}$ piece of subdata $Y_i$. In some embodiments, the first communication apparatus may send indication information to the second communication apparatus, to indicate a compression parameter (for example, including at least one of a coding scheme parameter, a quantization precision parameter, and a quantity of columns of subdata) of the compressed data $Z_i$. The indication information is described below.

For example, if the first communication apparatus further processes the sparse matrix $X_i$ of the $i^{th}$ piece of subdata $Y_i$ to obtain the location indication information and the element sequence shown in FIG. 6, the second communication apparatus decompresses the compressed data $Z_i$, to obtain the dictionary matrix $D_i'$, the location indication information, and the element sequence, and then determines the sparse matrix $X_i'$ based on the location indication information and the element sequence.

In S250, the second communication apparatus may construct the $i^{th}$ piece of subdata $Y_i'$ based on the obtained dictionary matrix $D_i'$, the obtained sparse matrix $X_i'$, and the $i^{th}$ piece of subdata $Y_i$ expressed by using the dictionary matrix $D_i'$ based on the sparse matrix $X_i'$.

The second communication apparatus decompresses each piece of subdata and constructs each piece of subdata based on a compression manner used for each piece of other subdata in the M pieces of subdata, to construct the second data, so as to implement data compression and transmission between the first communication apparatus and the second communication apparatus.

In some embodiments, after data compression is performed on the M pieces of subdata of the first data, data with a large amount still occupies a large quantity of transmission resources, or the second communication apparatus requires content of the first data transmitted by the first communication apparatus to be complete and rich. In this case, the M pieces of subdata of the first data may be compressed and transmitted in an incremental manner. The following three possible implementations may be included but are not limited to the following three possible implementations.

Manner 1: The first communication apparatus determines some elements in the sparse matrix $X_i$ as first elements, and determines an element other than the first elements in the sparse matrix $X_i$ as a second element. The first communication apparatus determines first compressed data $Z_i'$ of the $i^{th}$ piece of subdata $Y_i$ for the first element, and determines second compressed data $Z_i''$ of the $i^{th}$ piece of subdata $Y_i$ for the second element. Further, the first communication apparatus transmits the first compressed data $Z_i'$ in an initial transmission phase, and transmits the second compressed data $Z_i''$ in an incremental transmission phase.

For example, the first communication apparatus determines first location indication information and a first element sequence based on the first element, performs data compression on the dictionary matrix $D_i$, and the first location indication information and the first element sequence that are of the sparse matrix $X_i$, to obtain the first compressed data $Z_i'$ of the $i^{th}$ piece of subdata $Y_i$, and transmits the first compressed data $Z_i'$ in the initial transmission phase; and the first communication apparatus determines second location indication information and a second element sequence based on the second element, performs data compression on the second location indication information and the second element sequence that are of the sparse matrix $X_i$, to obtain the second compressed data $Z_i''$ of the $i^{th}$ piece of subdata $Y_i$, and transmits the second compressed data $Z_i''$ in the incremental transmission phase.

Correspondingly, the second communication apparatus decompresses the first compressed data $Z_i'$ of the $i^{th}$ piece of subdata $Y_i$, to obtain the dictionary matrix $D_i'$, and first location indication information and a first element sequence that are of the sparse matrix $X_i'$, and determines the sparse matrix $X_i'$ based on the first location indication information and the first element sequence; the second communication apparatus decompresses the second compressed data $Z_i''$ of the $i^{th}$ piece of subdata $Y_i$, to obtain second location indication information and a second element sequence that are of the sparse matrix $X_i'$, and updates the sparse matrix $X_i'$ based on the second location indication information and the second element sequence, or in other words, determines the sparse matrix $X_i'$ based on the first location indication information, the first element sequence, the second location indication information, and the second element sequence; and then, the second communication apparatus constructs the $i^{th}$ piece of subdata $Y_i'$ based on the dictionary matrix $D_i'$ and the sparse matrix $X_i'$.

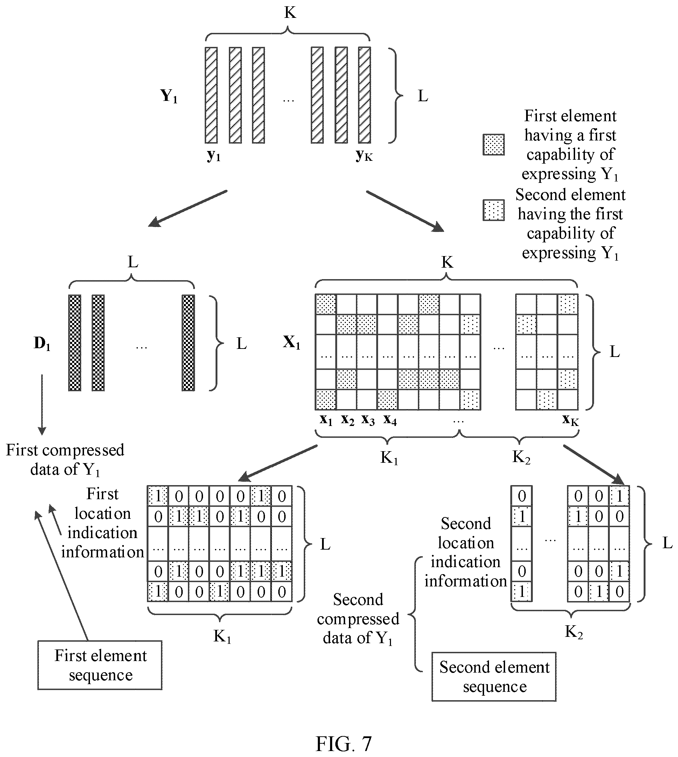

The first element may be preset or configured by a network device. This is not limited in this application. The first element may be an element in a preset column (for example, first $K_1$ columns shown in FIG. 7) in the sparse matrix $X_i$; the first element may be an element in a preset row (for example, a row 1, a row 3, or a row 8) in the sparse matrix $X_i$; or the first element may be an element at a preset location (for example, a column 1 and a row 1, a column 2 and a row 2, a column 3 and a row 3, ...) in the sparse matrix $X_i$. This is not limited in this application.

The first location indication information indicates whether the first element in the sparse matrix $X_i$ has the first capability of expressing the $i^{th}$ piece of subdata $Y_i$, and the first element sequence includes a first element that has the first capability of expressing the $i^{th}$ piece of subdata $Y_i$. Similar to the location indication information in the foregoing examples, the first location indication information may include a tree structure, a bitmap, a location index, and the like. This is not limited in this application. For example, the first location indication information is a first bitmap. With reference to FIG. 7, bits in the first bitmap one-to-one correspond to first elements in the sparse matrix $X_i$, and a bit in the first bitmap indicates whether a corresponding first element in the sparse matrix $X_i$ has the first capability of expressing the $i^{th}$ piece of subdata $Y_i$. For example, when a bit in the first bitmap is 1, it indicates that a corresponding first element in the sparse matrix $X_i$ has the first capability of expressing the $i^{th}$ piece of subdata $Y_i$; or when a bit in the first bitmap is 0, it indicates that a corresponding first element in the sparse matrix $X_i$ does not have the first capability of expressing the $i^{th}$ piece of subdata $Y_i$. For another example (not shown in FIG. 7), when a bit in the first bitmap is 0, it indicates that a corresponding first element in the sparse matrix $X_i$ has the first capability of expressing the $i^{th}$ piece of subdata $Y_i$; or when a bit in the first bitmap is 1, it indicates that a corresponding first element in the sparse matrix $X_i$ does not have the first capability of expressing the $i^{th}$ piece of subdata $Y_i$.

The second location indication information indicates whether a second element in the sparse matrix $X_i$ has the first capability of expressing the $i^{th}$ piece of subdata $Y_i$, and the second element sequence includes a second element that has the first capability of expressing the $i^{th}$ piece of subdata $Y_i$. Similar to the first location indication information, the second location indication information may include a tree structure, a bitmap, a location index, and the like. This is not limited in this application. For example, the second location indication information is a second bitmap. With reference to FIG. 7, bits in the second bitmap one-to-one correspond to second elements in the sparse matrix $X_i$, and the bits in the second bitmap indicate whether the corresponding second elements in the sparse matrix $X_i$ have the first capability of expressing the $i^{th}$ piece of subdata $Y_i$. For example, when a bit in the second bitmap is 1, it indicates that a corresponding second element in the sparse matrix $X_i$ has the first capability of expressing the $i^{th}$ piece of subdata $Y_i$; or when a bit in the second bitmap is 0, it indicates that a corresponding second element in the sparse matrix $X_i$ does not have the first capability of expressing the $i^{th}$ piece of subdata $Y_i$. For another example, when a bit in the second bitmap is 0, it indicates that a corresponding second element in the sparse matrix $X_i$ has the first capability of expressing the $i^{th}$ piece of subdata $Y_i$; or when a bit in the second bitmap is 1, it indicates that a corresponding second element in the sparse matrix $X_i$ does not have the first capability of expressing the $i^{th}$ piece of subdata $Y_i$.

For example, the first communication apparatus may determine whether each first element in the sparse matrix $X_i$ has the first capability of expressing the $i^{th}$ piece of subdata $Y_i$ based on the first element and a first capability threshold. For example, when an absolute value of a value of the first element is greater than the first capability threshold, the first communication apparatus determines that the first element has the first capability of expressing the $i^{th}$ piece of data $Y_i$; when an absolute value of a value of the first element is less than the first capability threshold, the first communication apparatus determines that the first element does not have the first capability of expressing the $i^{th}$ piece of subdata $Y_i$; or

when an absolute value of a value of the first element is equal to the first capability threshold, the first communication apparatus determines, based on an application scenario, the first element as a first element that has or does not have the first capability of expressing the $i^{th}$ piece of data $Y_i$. This is not limited in this application. Further, the first communication apparatus determines the first location indication information and the first element sequence based on whether each first element in the sparse matrix $X_i$ has the first capability of expressing the $i^{th}$ piece of subdata $Y_i$.

For example, the first communication apparatus may determine whether each second element in the sparse matrix $X_i$ has the first capability of expressing the $i^{th}$ piece of subdata $Y_i$ based on the second element and the first capability threshold. For example, when an absolute value of a value of the second element is greater than the first capability threshold, the first communication apparatus determines that the second element has the first capability of expressing the $i^{th}$ piece of data $Y_i$; when an absolute value of a value of the second element is less than the capability threshold, the first communication apparatus determines that the second element does not have the first capability of expressing the $i^{th}$ piece of subdata $Y_i$; or when an absolute value of a value of the second element is equal to the first capability threshold, the first communication apparatus determines, based on an application scenario, the second element as a second element that has or does not have the first capability of expressing the $i^{th}$ piece of data $Y_i$. This is not limited in this application. Further, the first communication apparatus determines the second location indication information and the second element sequence based on whether each second element in the sparse matrix $X_i$ has the first capability of expressing the $i^{th}$ piece of subdata $Y_i$.

With reference to FIG. 7, in a sparse matrix $X_1$, elements in first $K_1$ columns are first elements, and elements in last $K_2$ columns are second elements. In this case, the first communication apparatus determines first elements that have a first capability of expressing $Y_1$ based on element values of the first elements in the first $K_1$ columns in the sparse matrix $X_i$, forms a first element sequence by using the first elements that have the first capability of expressing $Y_1$, further determines first location indication information indicating the first elements that have the first capability of expressing $Y_1$, and then, determines first compressed data of $Y_1$ based on the first location indication information, the first element sequence, and a dictionary matrix $D_1$.

Still with reference to FIG. 7, the first communication apparatus determines second elements that have the first capability of expressing $Y_1$ based on element values of the second elements in the last $K_2$ columns in the sparse matrix $X_i$, forms a second element sequence by using the second elements that have the first capability of expressing $Y_1$, determines second location indication information indicating the second elements that have the first capability of expressing $Y_1$, and then, determines second compressed data of $Y_1$ based on the second location indication information and the second element sequence.

It should be noted that the dictionary matrix $D_i$ may not be repeatedly transmitted in the incremental transmission phase, to reduce a waste of transmission resources.

In Manner 1, the first communication apparatus may determine, based on a preset or preconfigured time-frequency resource, whether to classify elements in the $i^{th}$ piece of subdata $Y_i$ into the first element and the second element, and further determine the first location indication information and the first element sequence that correspond to the first element, and the second location indication information and the second element sequence that correspond to the second element. Alternatively, the first communication apparatus may first determine an element that is in the $i^{th}$ piece of subdata $Y_i$ and that meets the first capability threshold, and determine, based on a quantity of elements that meet the first capability threshold, whether the compressed data of the $i^{th}$ piece of subdata $Y_i$ can be transmitted on a preset or preconfigured time-frequency resource. If determining that the compressed data of the $i^{th}$ piece of subdata $Y_i$ cannot be transmitted on the preset or preconfigured time-frequency resource because a time-frequency resource occupied by the compressed data of the $i^{th}$ piece of subdata $Y_i$ is greater than the preset or preconfigured time-frequency resource, the first communication apparatus classifies the elements in the $i^{th}$ piece of subdata $Y_i$ into the first element and the second element, and then, determines the first location indication information and the first element sequence that correspond to the first element, and the second location indication information and the second element sequence that correspond to the second element.

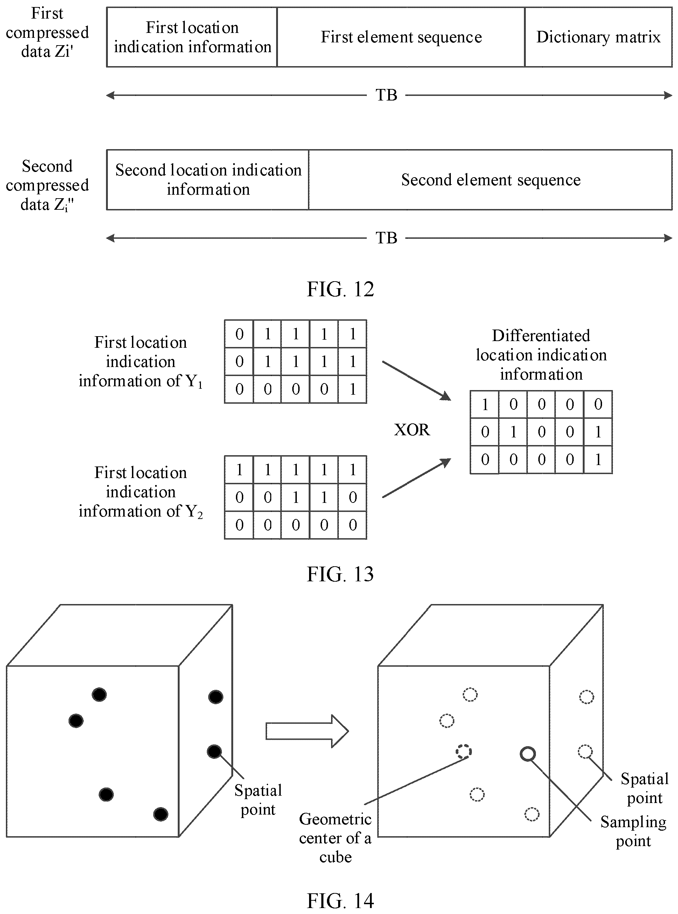

For example, refer to FIG. 12. The first communication apparatus needs to transmit the compressed data $Z_i$ of the $i^{th}$ piece of subdata $Y_i$ on one transport resource block (transport block, TB). When the compressed data $Z_i$ obtained by performing data compression on an element sequence including all elements that are in the sparse matrix $X_i$ and that have the capability of expressing of the $i^{th}$ piece of subdata $Y_i$ exceeds one TB (for example, a size of one TB is 3824 bits), the first communication apparatus determines a size of a remaining resource other than the dictionary matrix $D_i$ in one TB, determines a quantity of first elements (for example, determines a value of $K_1$ in FIG. 7) based on the size of the remaining resource in the TB, and after performing data compression on the first location indication information and the first element sequence that are determined based on the first element, and the dictionary matrix $D_i$, carries the obtained first compressed data $Z_i'$ of the $i^{th}$ piece of subdata $Y_i$ in the TB and sends the TB to the second communication apparatus; and in the incremental transmission phase, after performing data compression on the second location indication information and the second element sequence that are determined based on the second element, the first communication apparatus carries the obtained second compressed data $Z_i''$ of the $i^{th}$ piece of subdata $Y_i$ in another TB and sends the another TB to the second communication apparatus.

For ease of understanding, Manner 1 is described by using only an example in which the elements in the sparse matrix $X_i$ are classified into the first element and the second element, but is not limited thereto. In an understanding, the first communication apparatus may further classify the elements in the sparse matrix $X_i$ into more types, for example, a first element, a second element, and a third element. In another understanding, the first communication apparatus may further classify the second element into a third element, a fourth element, and the like, to perform further incremental transmission. Classification of element types and determining of location indication information and an element sequence for each element type are similar to implementations in Manner 1. For brevity, details are not described again.

Manner 2: The first communication apparatus determines first compressed data $Z_i'$ of the $i^{th}$ piece of subdata $Y_i$ for an element that is in the sparse matrix $X_i$ and that has the first capability of expressing $Y_i$, and determines third compressed data $Z_i'''$ of the $i^{th}$ piece of subdata $Y_i$ for an element that is in the sparse matrix $X_i$ and that has a second capability of expressing $Y_i$ or N elements at preset locations. Further, the first communication apparatus transmits the first compressed data $Z_i'$ in an initial transmission phase, and transmits the third compressed data $Z_i'''$ in an incremental transmission phase.

For example, in the initial transmission phase, the first communication apparatus determines the element that is in the sparse matrix $X_i$ and that has the first capability of expressing $Y_i$, and determines first location indication information and a first element sequence based on the element that has the first capability of expressing $Y_i$.

Correspondingly, the second communication apparatus decompresses the first compressed data $Z_i'$ of the $i^{th}$ piece of subdata $Y_i$, to obtain the dictionary matrix $D_i'$, and first location indication information and a first element sequence that are of the sparse matrix $X_i'$. In some embodiments, the second communication apparatus may determine the sparse matrix $X_i'$ based on the first location indication information and the first element sequence.

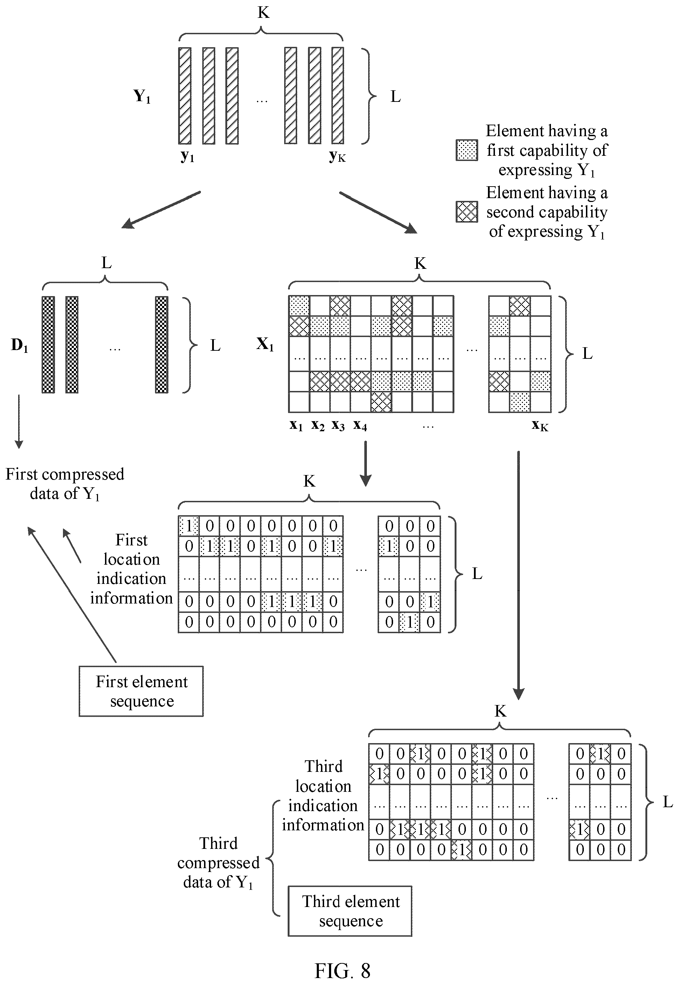

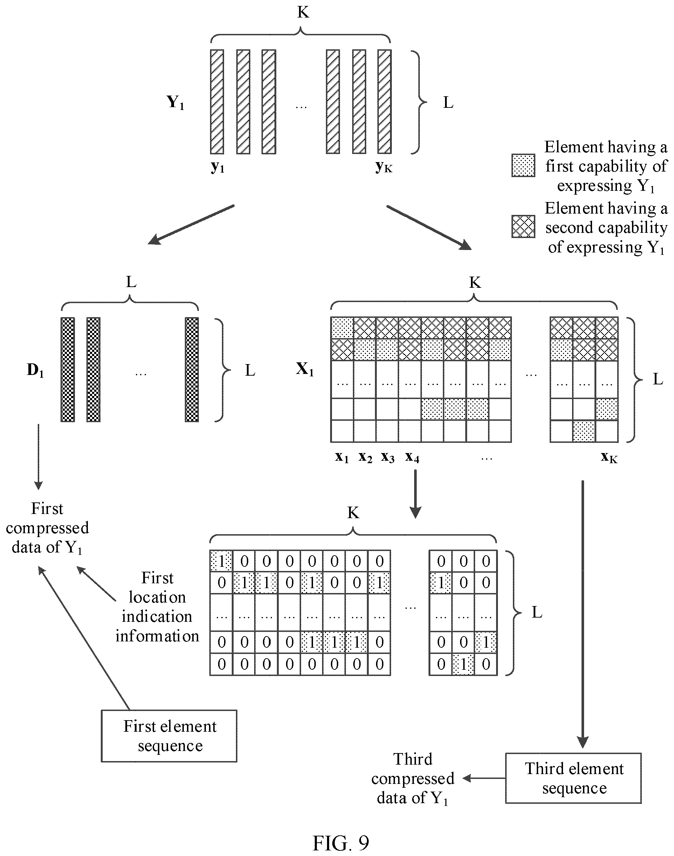

The first location indication information indicates whether an element in the sparse matrix $X_i$ has the first capability of expressing the $i^{th}$ piece of subdata $Y_i$, and the first element sequence includes an element that has the first capability of expressing the $i^{th}$ piece of subdata $Y_i$. Similar to the location indication information in the foregoing examples, the first location indication information may include a tree structure, a bitmap, a location index, and the like. This is not limited in this application. For example, the first location indication information is a first bitmap. With reference to FIG. 8 or FIG. 9, bits in the first bitmap one-to-one correspond to elements in the sparse matrix $X_i$, and a bit in the first bitmap indicates whether a corresponding element in the sparse matrix $X_i$ has the first capability of expressing the $i^{th}$ piece of subdata $Y_i$. This is similar to the related example in FIG. 7. Details are not described herein again.

For example, the first communication apparatus may determine whether each element in the sparse matrix $X_i$ has the first capability of expressing the $i^{th}$ piece of subdata $Y_i$ based on the element and a first capability threshold. Determining whether an element has the first capability of expressing the $i^{th}$ piece of subdata $Y_i$ is similar to determining of the first capability of the first element in the foregoing example. Details are not described herein again. Further, the first communication apparatus determines the first location indication information and the first element sequence based on whether each element in the sparse matrix $X_i$ has the first capability of expressing the $i^{th}$ piece of subdata $Y_i$.

In a first example of Manner 2, third location indication information indicates whether an element in the sparse matrix $X_i$ has the second capability of expressing the $i^{th}$ piece of subdata $Y_i$, and the third element sequence includes an element that has the second capability of expressing the $i^{th}$ piece of subdata $Y_i$. Similar to the first location indication information, the third location indication information may include a tree structure, a bitmap, a location index, and the like. This is not limited in this application. For example, the third location indication information is a third bitmap. With reference to FIG. 8, bits in the third bitmap one-to-one correspond to elements in the sparse matrix $X_i$, and the bits in the third bitmap indicate whether the corresponding elements in the sparse matrix $X_i$ have the second capability of expressing the $i^{th}$ piece of subdata $Y_i$.

Based on the foregoing first example, the first communication apparatus may determine whether each element in the sparse matrix $X_i$ has the second capability of expressing the $i^{th}$ piece of subdata $Y_i$ based on the element, the first capability threshold, and a second capability threshold. For example, when an absolute value of a value of the element is less than the first capability threshold and greater than the second capability threshold, the first communication apparatus determines that the element has the second capability of expressing the $i^{th}$ piece of data $Y_i$; when an absolute value of a value of the element is greater than the first capability threshold or less than the second capability threshold, the first communication apparatus determines that the element does not have the second capability of expressing the $i^{th}$ piece of subdata $Y_i$; or when an absolute value of a value of the element is equal to the first capability threshold or the second capability threshold, the first communication apparatus determines the element as an element that has or does not have the second capability of expressing the $i^{th}$ piece of data $Y_i$. This is not limited in this application. Further, the first communication apparatus determines the third location indication information and a third element sequence based on whether each element in the sparse matrix $X_i$ has the second capability of expressing the $i^{th}$ piece of subdata $Y_i$.

In some possible implementations, the first capability threshold is greater than the second capability threshold. For example, the first capability threshold is $10^{-4}$, the second capability threshold is $10^{-5}$, an element that is in the sparse matrix $X_i$ and whose absolute value of a value is greater than $10^{-4}$ is an element that has the first capability of expressing the

$i^{th}$ piece of subdata $Y_i$, and an element that is in the sparse matrix $X_i$ and whose absolute value of a value falls within a numerical range $[10^{-5}, 10^{-4}]$ is an element that has the second capability of expressing the $i^{th}$ piece of subdata $Y_i$.

Correspondingly, the second communication apparatus may decompress the third compressed data $Z_i'''$ of the $i^{th}$ piece of subdata $Y_i$, to obtain third location indication information and a third element sequence that are of the sparse matrix $X_i'$. In some embodiments, the second communication apparatus may update the sparse matrix $X_i'$ based on the third location indication information and the third element sequence. In some other embodiments, the second communication apparatus may determine the sparse matrix $X_i'$ based on the first location indication information, the first element sequence, the third location indication information, and the third element sequence. Further, the second communication apparatus constructs the $i^{th}$ piece of subdata $Y_i'$ based on the dictionary matrix $D_i'$ and the sparse matrix $X_i'$.

In the first example of Manner 2, the transmitted second compressed data helps reduce a construction error generated when the second communication apparatus performs data construction.

In a second example of Manner 2, a third element sequence includes N elements in the sparse matrix $X_i$ other than an element included in the first element sequence, where N is a positive integer. It should be understood that the N elements may be distributed in different rows and different columns in the sparse matrix $X_i$, or the N elements may be elements in a preset row or a preset column in the sparse matrix $X_i$. For example, with reference to FIG. 9, the N elements are elements in first two rows in a sparse matrix $X_1$.

Based on the foregoing second example, the first communication apparatus performs data compression on the third element sequence to obtain third compressed data $Z_i'''$ of the $i^{th}$ piece of subdata $Y_i$. It should be understood that the N elements may be preset or preconfigured. That is, the first communication apparatus does not need to indicate, to the second communication apparatus, locations that are of the N elements and that are in the sparse matrix $X_i$. Therefore, location indication information does not need to be transmitted.

Correspondingly, the second communication apparatus may decompress the third compressed data $Z_i'''$ of the $i^{th}$ piece of subdata $Y_i$, to obtain a third element sequence of the sparse matrix $X_i'$. In some embodiments, the second communication apparatus may update the sparse matrix $X_i'$ based on the third element sequence. In some other embodiments, the second communication apparatus may determine the sparse matrix $X_i'$ based on the first location indication information, the first element sequence, and the third element sequence. Further, the second communication apparatus constructs the $i^{th}$ piece of subdata $Y_i'$ based on the dictionary matrix $D_i'$ and the sparse matrix $X_i'$.

Similar to Manner 1, in Manner 2, the dictionary matrix $D_i$ does not need to be transmitted in the incremental transmission phase. Compared with Manner 1, in Manner 2, whether incremental transmission is required may be flexibly selected. For example, in a service scenario, when the second communication apparatus can obtain sufficient service information in the first data through decompression based on the first compressed data $Z_i'$, incremental transmission does not need to be performed.

In the second example of Manner 2, the second compressed data does not include location indication information, thereby reducing resource overheads.

Manner 3: The first communication apparatus determines some elements in the sparse matrix $X_i$ as first elements, and determines an element other than the first elements in the sparse matrix $X_i$ as a second element. The first communication apparatus determines, for the first element that is in the first element and that has the first capability of expressing $Y_i$, first compressed data $Z_i'$ of the $i^{th}$ piece of subdata $Y_i$, and determines, for a second element that is in the first element and that has the first capability of expressing $Y_i$, second compressed data $Z_i''$ of the $i^{th}$ piece of subdata $Y_i$, and further determines, for an element (including the first element and the second element) that is in the sparse matrix $X_i$ and that has a second capability of expressing $Y_i$ or N elements at preset locations, third compressed data $Z_i'''$ of the $i^{th}$ piece of subdata $Y_i$. Further, the first communication apparatus transmits the first compressed data $Z_i'$ in an initial transmission phase, and transmits the second compressed data $Z_i''$ and the third compressed data $Z_i'''$ in an incremental transmission phase.

In another understanding of Manner 3, the first communication apparatus may determine elements that are in the sparse matrix $X_i$ and that have the first capability of expressing $Y_i$, and classify the elements that have the first capability of expressing $Y_i$ into the first element and the second element; and then, the first communication apparatus determines, for the first element that has the first capability of expressing $Y_i$, the first compressed data $Z_i'$ of the $i^{th}$ piece of subdata $Y_i$, determines, for the second element that has the first capability of expressing $Y_i$, the second compressed data $Z_i''$ of the $i^{th}$ piece of subdata $Y_i$, and determines, for the element that is in the sparse matrix $X_i$ and that has the second capability of expressing $Y_i$ or the N elements at preset locations, the third compressed data $Z_i'''$ of the $i^{th}$ piece of subdata $Y_i$.

In Manner 3, for a process in which the first communication apparatus determines capabilities (including the first capability and/or the second capability) of elements (including the first element and/or the second element), refer to the foregoing examples. For brevity, details are not described again. In Manner 3, for a process in which the first communication apparatus compresses and transmits the first compressed data $Z_i'$, the second compressed data $Z_i''$, and the third compressed data $Z_i'''$, refer to the foregoing examples. For brevity, details are not described herein again.

In some embodiments, the second communication apparatus may decompress the third compressed data $Z_i'''$, to obtain third location indication information and a third element sequence that are of the sparse matrix $X_i'$, and determine the

sparse matrix $X_i'$ based on the third location indication information and the third element sequence that are of the sparse matrix $X_i'$, and at least one of the following: first location indication information and a first element sequence that are of the sparse matrix $X_i'$, or second location indication information and a second element sequence that are of the sparse matrix $X_i'$. For a manner of determining the first location indication information, the first element sequence, second location indication information, and a second element sequence that are of the sparse matrix $X_i'$, refer to the foregoing embodiments. Details are not described herein again.

In some other embodiments, the second communication apparatus may decompress the third compressed data $Z_i'''$, to obtain third location indication information and a third element sequence that are of the sparse matrix $X_i'$, and further, the second communication apparatus may first determine the sparse matrix $X_i'$ based on at least one of the following: first location indication information and a first element sequence that are of the sparse matrix $X_i'$, or second location indication information and a second element sequence that are of the sparse matrix $X_i'$. Further, the second communication apparatus updates the sparse matrix $X_i'$ based on the third location indication information and the third element sequence that are of the sparse matrix $X_i'$.

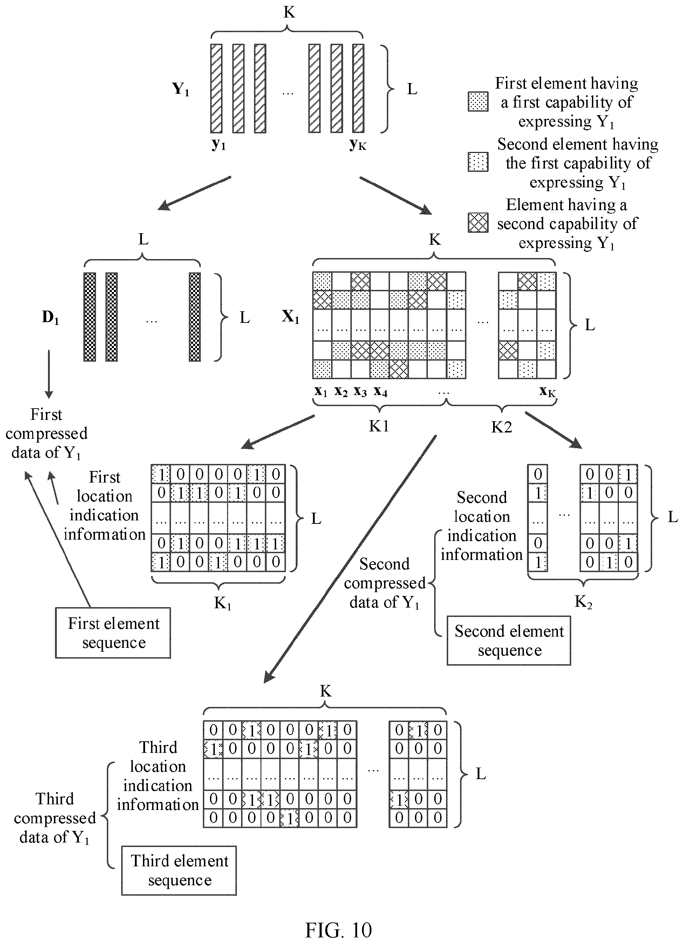

With reference to FIG. 10, in a sparse matrix $X_1$, elements in first $K_1$ columns are first elements, and elements in last $K_2$ columns are second elements. In this case, the first communication apparatus determines, from the first elements in the first $K_1$ columns, a first element that has a first capability of expressing $Y_1$, and determines, from the second elements in the last $K_2$ columns, a second element that has the first capability of expressing $Y_1$; the first communication apparatus determines first location indication information and a first element sequence based on the first element that has the first capability of expressing $Y_1$, and performs data compression on a dictionary matrix $D_1$, the first location indication information, and the first element sequence, to obtain the first compressed data $Z_i'$ of the $i^{th}$ piece of subdata $Y_i$; the first communication apparatus determines second location indication information and a second element sequence based on the second element that has the first capability of expressing $Y_1$, and performs data compression on the second location indication information and the second element sequence, to obtain the second compressed data $Z_i''$ of the $i^{th}$ piece of subdata $Y_i$; and further, in response to incremental transmission scheduling, the first communication apparatus may determine, from elements (including the first element and the second element) in the sparse matrix $X_1$, an element that has a second capability of expressing $Y_1$, determine third location indication information and a third element sequence based on the element that has the second capability of expressing $Y_1$, and perform data compression on the third location indication information and the third element sequence, to obtain the third compressed data $Z_i'''$ of the $i^{th}$ piece of subdata $Y_i$.

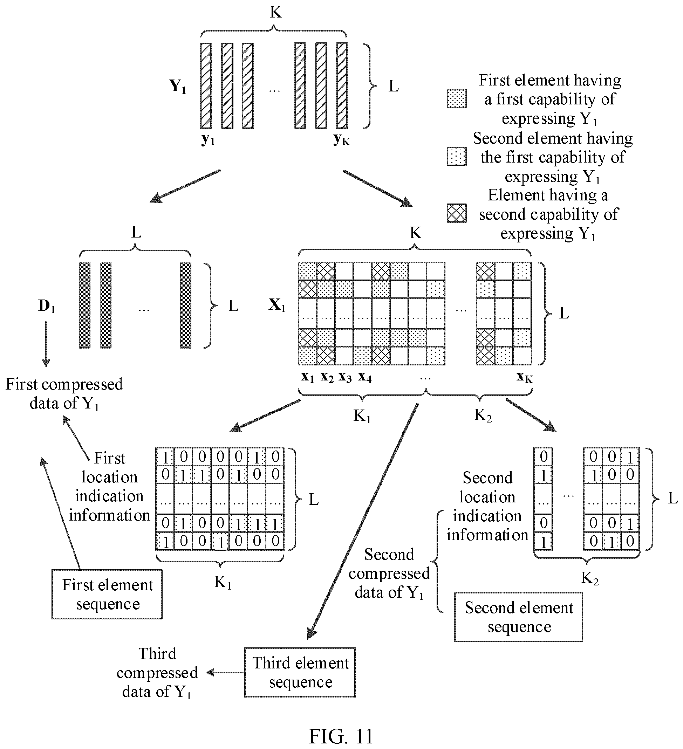

With reference to FIG. 11, for a manner in which the first communication apparatus determines the first compressed data $Z_i'$ and the second compressed data $Z_i''$ of the $i^{th}$ piece of subdata $Y_i$, refer to descriptions of examples shown in FIG. 10. Details are not described herein again. Further, in response to incremental transmission scheduling, the first communication apparatus may determine the third element sequence based on N elements at preset locations in elements (including the first element and the second element) in the sparse matrix $X_1$, and perform data compression on the third element sequence, to obtain the third compressed data $Z_i'''$ of the $i^{th}$ piece of subdata $Y_i$. For descriptions of the N elements, refer to the foregoing examples. Details are not described herein again.

Compared with Manner 1 and Manner 2, Manner 3 has higher transmission reliability, and is more conducive to data construction performed by the second communication apparatus based on the received compressed data.

In some embodiments, at least two pieces of subdata (for example, the $i^{th}$ piece of subdata and an $(i-1)^{th}$ piece of subdata, the $i^{th}$ piece of subdata and an $(i+1)^{th}$ piece of subdata, or any two pieces of subdata that are not adjacent to each other) in the M pieces of subdata are compressed by using a manner in any one of the foregoing embodiments. In this case, to further improve compression performance, the first communication apparatus may perform exclusive OR on location indication information corresponding to the sparse matrix $X_i$ and location indication information corresponding to a sparse matrix $X_{i-1}$, and use differentiated location indication information obtained through exclusive OR as the location indication information corresponding to the sparse matrix $X_i$.

The location indication information corresponding to the sparse matrix $X_i$ may include at least one of the first location indication information, the second location indication information, and the third location indication information that are of the sparse matrix $X_i$. The location indication information corresponding to the sparse matrix $X_{i-1}$ includes at least one of first location indication information, second location indication information, and third location indication information that are of the sparse matrix $X_{i-1}$. For example, in the initial transmission phase, the differentiated location indication information may be determined based on the first location indication information of the sparse matrix $X_i$ and the first location indication information of the sparse matrix $X_{i-1}$. In the incremental transmission phase, the differentiated location indication information may be determined based on the second location indication information of the sparse matrix $X_i$ and the second location indication information of the sparse matrix $X_{i-1}$, or may be determined based on the third location indication information of the sparse matrix $X_i$ and the third location indication information of the sparse matrix $X_{i-1}$.

In this application, the location indication information corresponding to the sparse matrix $X_{i-1}$ may alternatively be expressed as location indication information of the sparse matrix $X_{i-1}$ and location indication information of an $(i-1)^{th}$ piece of subdata $Y_{i-1}$. The location indication information corresponding to the sparse matrix $X_{i-1}$, the location indication information of the sparse matrix $X_{i-1}$, and the location indication information of the $(i-1)^{th}$ piece of subdata $Y_{i-1}$ are

alternately used and express consistent meanings in this application.

In some embodiments, the first communication apparatus may first determine whether to use the differentiated location indication information as the first location indication information of the sparse matrix $X_i$. For example, when a first proportion of the differentiated location indication information is greater than or equal to a proportion threshold, the first communication apparatus uses the differentiated location indication information as the first location indication information of the sparse matrix $X_i$. The first proportion is a proportion of a quantity of bits with a first value or a second value in bits of the differentiated location indication information to a quantity of all the bits of the differentiated location indication information, the first value indicates that a corresponding element in the sparse matrix $X_i$ has the first capability of expressing the $i^{th}$ piece of subdata $Y_i$, and the second value indicates that a corresponding element in the sparse matrix $X_i$ does not have the first capability of expressing the $i^{th}$ piece of subdata $Y_i$. It should be noted that, when the first proportion is greater than or equal to the proportion threshold, it indicates a large difference between a quantity of bits with the first value and a quantity of bits of the second data in the bits of the differentiated location indication information. In this case, the differentiated location indication information has a large compressible amount, and compression performance of the $i^{th}$ piece of subdata can be improved by replacing the first location indication information of the sparse matrix $X_i$ with the differentiated location indication information. On the contrary, if a compressible amount of the differentiated location indication information is small, the first communication apparatus still performs data compression on the $i^{th}$ piece of subdata based on the original first location indication information.

Optionally, the proportion threshold is a preset value; or the proportion threshold may be dynamically adjusted based on the first location indication information that is of the sparse matrix $X_i$ and that is determined by the first communication apparatus. For example, the first communication apparatus determines the proportion threshold based on the first location indication information of the sparse matrix $X_i$, and a proportion of the quantity of bits with the first value or the second value to a quantity of all bits of the first location indication information. It should be understood that, when the first proportion of the differentiated location indication information is greater than or equal to the proportion threshold, it indicates that the differentiated location indication information has a large compressible amount compared with the first location indication information, and the compression performance of the $i^{th}$ piece of subdata can be improved by replacing the first location indication information that is of the sparse matrix $X_i$ and that is determined by the first communication apparatus with the differentiated location indication information.

In the foregoing embodiments, only an example in which the location indication information is the first location indication information is used for description. When the location indication information is the second location indication information or the third location indication information, an implementation process is similar to that in the foregoing examples. Details are not described herein again.

Optionally, the first communication apparatus may send second indication information to the second communication apparatus, where the second indication information includes at least information indicating whether the location indication information of the sparse matrix $X_i$ is differentiated location indication information. For example, the second indication information may be indicated by using a 1-bit field. For example, when the 1-bit field is "1", it indicates that the location indication information of the sparse matrix $X_i$ is the differentiated location indication information; or when the 1-bit field is "0", it indicates that the location indication information of the sparse matrix $X_i$ is non-differentiated location indication information (that is, location indication information that is determined by the first communication apparatus and that corresponds to an element sequence of the sparse matrix $X_i$).

Optionally, the first value may be "1", and/or the second value may be "2".

For example, the first location indication information is a first bitmap, and the differentiated location indication information is a differentiated bitmap. After determining a first bitmap of the sparse matrix $X_i$, the first communication apparatus performs exclusive OR on the first bitmap of the sparse matrix $X_i$ and a first bitmap of the sparse matrix $X_{i-1}$, and the first communication apparatus may further use a differentiated bitmap as the first bitmap of the sparse matrix $X_i$, and perform data compression on the first bitmap of the sparse matrix $X_i$, the dictionary matrix $D_i$, and the first element sequence of the sparse matrix $X_i$, to obtain the first compressed data $Z_i'$ of the $i^{th}$ piece of subdata $Y_i$. Refer to FIG. 13. A differentiated bitmap is obtained by performing exclusive OR (XOR) on a first bitmap of a first piece of subdata $Y_1$ in the M pieces of subdata and a first bitmap of a second piece of subdata $Y_2$ in the M pieces of subdata. When a difference between the first bitmap of the first piece of subdata $Y_1$ and the first bitmap of the second piece of subdata $Y_2$ in the M pieces of subdata is large, there are more bits whose values are "1" in the differentiated bitmap; or when a difference between the first bitmap of the first piece of subdata $Y_1$ and the first bitmap of the second piece of subdata $Y_2$ in the M pieces of subdata is small, there are more bits whose values are "0" in the differentiated bitmap. It is assumed that the proportion threshold is determined based on bits in the first bitmap of $Y_2$, the proportion threshold may be a ratio of a quantity 8 of bits with a second value "0" to a quantity 15 of all bits, that is, 8/15, a first proportion of the differentiated bitmap is a ratio of a quantity 11 of bits with the second value "0" to a quantity 15 of all bits, that is, 11/15, and the first proportion of the differentiated bitmap is greater than the proportion threshold. In this case, the differentiated bitmap has a larger compressible amount than the first bitmap. Therefore, compression performance can be improved by replacing the first bitmap with the differentiated bitmap and performing data compression on the second piece of subdata $Y_2$.

When the first data includes point cloud data, refer to the preprocessing process shown in FIG. 4. The first communication apparatus may sample initial point cloud data, to obtain the point cloud data in the first data. FIG. 14 is a diagram of a sampling process at a first layer. With reference to the example shown in FIG. 14, in some embodiments, the first communication apparatus may perform, by using cubes with a preset side length, space division on Euclidean space in which the initial point cloud data is located, and use a geometric center of spatial points in each cube as a sampling point of the cube.

Optionally, coordinates of the geometric center of the spatial points in the cube may be an average value of coordinates of all the spatial points in the cube. For example, there are three spatial points in a cube, and coordinates of the three spatial points are respectively represented by $s_1$, $s_2$, and $s_3$. In this case, coordinates of a geometric center of the spatial points in the cube may be represented as $(s_1+s_1 s_3)/3$.

In some other embodiments, the first communication apparatus may perform, by using cubes with a preset side length, spatial division on Euclidean space in which the initial point cloud data is located, and use a weighted geometric center of spatial points in a cube as a sampling point of the cube. The weighted geometric center may be a weighted average value of coordinates of all spatial points in the cube, weights of all the spatial points may be the same or different, and a value of a weight corresponding to each spatial point may be greater than or equal to 0 and less than or equal to 1. This is not limited in this application. For example, there are three spatial points in a cube, coordinates of the three spatial points are respectively represented by $s_1$, $s_2$, and $s_3$, and weights respectively corresponding to the three spatial points are $w_1$, $w_2$, and $w_3$. In this case, coordinates of a geometric center of the spatial points in the cube may be represented as $(w_1 \times s_1 + w_2 \times s_2 + w_3 \times s_3)/3$.

It may be understood that a data amount of the point cloud data can be reduced by using a geometric center or a weighted geometric center of spatial points in a cube as a sampling point of the cube. Further, the geometric center of the spatial points in the cube is used as the sampling point of the cube, so that processing complexity in a sampling process can be reduced; and the weighted geometric center of the spatial points in the cube is used as the sampling point of the cube, so that the sampling point may be adjusted by adjusting a weight. This implements flexible control over sampling.

Optionally, the side length of the cube may be a preset value or preconfigured. This is not limited in this application.

The first communication apparatus may send the side length of the cube to the second communication apparatus through indication information, so that the second data constructed by the second communication apparatus is closer to the first data. This improves reliability of compression and transmission.

Generally, in Euclidean space, original point cloud data is seamlessly covered by using a plurality of consecutive cubes. Certainly, this is not limited in this application. For example, there may be a spatial gap between two cubes.

For the foregoing example, it should be noted that a geometric center of spatial points in a cube is different from a geometric center of the cube. As shown in FIG. 14, the geometric center of the cube is an intersection point of two body diagonals, and the geometric center of the spatial points in the cube is a most central location that is of the spatial points and that is determined based on locations of the spatial points in the cube.

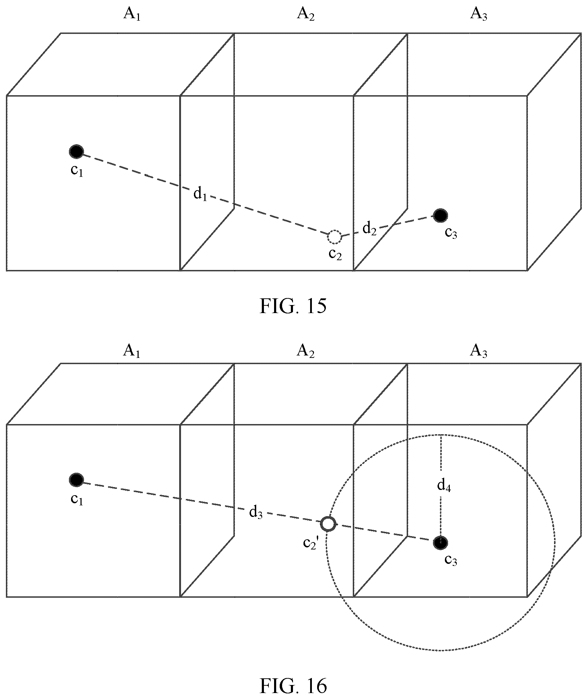

FIG. 15 is a diagram of a sampling process at a second layer. With reference to the example shown in FIG. 15, to further improve a data compression rate, the first communication apparatus may determine a distance between sampling points of adjacent cubes; when the distance between the sampling points of the adjacent cubes is less than or equal to a first distance threshold, the first communication apparatus deletes a sampling point of one of the adjacent cubes; and after performing sampling on every two adjacent cubes, the first communication apparatus forms the first data by using reserved sampling points. For example, if a distance $d_1$ between $c_1$ in a cube $A_1$ and $c_2$ in a cube $A_2$ is greater than the first distance threshold, $c_1$ and $c_2$ are reserved; and if a distance $d_2$ between $c_2$ in the cube $A_2$ and $c_3$ in a cube $A_3$ is less than or equal to the first distance threshold, $c_2$ in $A_2$ is deleted, or $c_3$ in $A_3$ may be deleted.

In some embodiments, the first communication apparatus may not perform the foregoing sampling process at a second layer, but form the first data by using determined sampling points in cubes.

In a process of constructing the second data, the second communication apparatus may perform interpolation on the second data, so that the second data is closer to the first data. This improves reliability of compression and transmission. For example, when a distance between two adjacent spatial points of the second data in Euclidean space is greater than or equal to a second distance threshold, the second communication apparatus performs interpolation between the two adjacent spatial points. With reference to FIG. 16, if a distance $d_3$ between $c_1$ in a cube $A_1$ and $c_3$ in a cube $A_3$ is greater than or equal to the second distance threshold, interpolation is performed in a cube $A_2$.

For example, the second communication apparatus may add a spatial point (that is, perform interpolation) at an intersection point of a connection line between two adjacent spatial points and a sideline of a circle, and in Euclidean space, one of the two adjacent spatial points is used as a center of the circle, and a third distance threshold is used as a radius. With reference to FIG. 16, the second communication apparatus adds a spatial point $c_2'$ at an intersection point of a circle that uses $c_3$ in the cube $A_3$ as a center and uses the third distance threshold $d_4$ as a radius and a connection line between $c_1$ in the cube $A_1$ and $c_3$ in the cube $A_3$.

It should be understood that, for the second communication apparatus, there may be no cube used for space division in Euclidean space. This is not limited in this application.

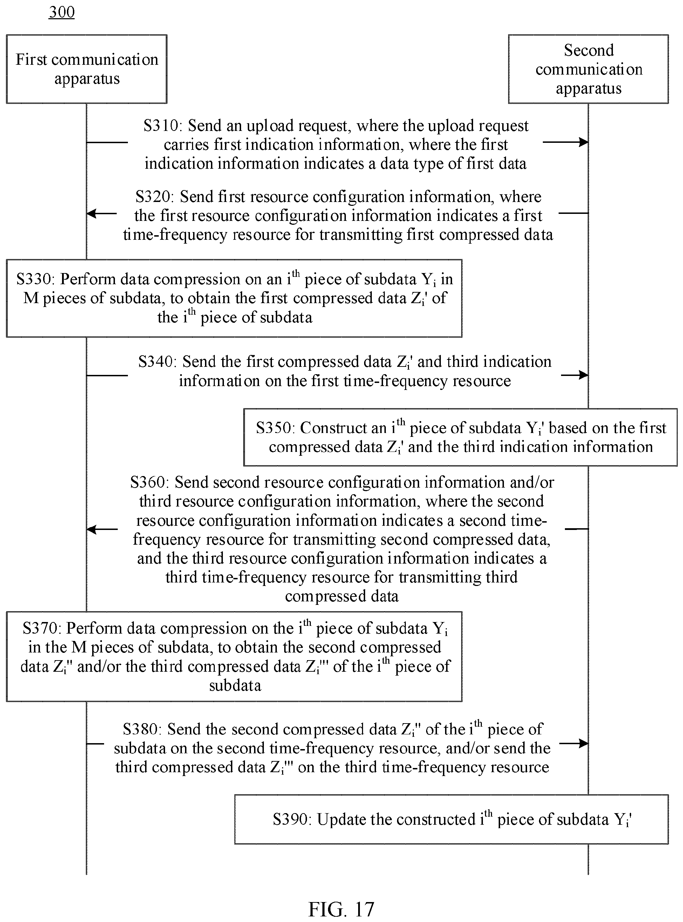

FIG. 17 is a schematic interaction flowchart of another data compression and transmission method according to an embodiment of this application. As shown in FIG. 17, a method 300 includes a part of or the entire process of S310 to S390:

S310: A first communication apparatus sends an upload request to a second communication apparatus, where the upload request carries first indication information, and the first indication information indicates a data type of first data. Correspondingly, the second communication apparatus receives the upload request sent by the first communication apparatus.

S320: The second communication apparatus sends first resource configuration information to the first communication apparatus, where the resource configuration information indicates a first time-frequency resource of first compressed data. Correspondingly, the first communication apparatus receives the resource configuration information sent by the second communication apparatus.

S330: The first communication apparatus performs data compression on an $i^{th}$ piece of subdata $Y_i$ in M pieces of subdata, to obtain the first compressed data $Z_i'$ of the $i^{th}$ piece of subdata.

S340: The first communication apparatus sends the first compressed data $Z_i'$ and third indication information on the first time-frequency resource. Correspondingly, the second communication apparatus receives the first compressed data $Z_i'$ and the third indication information on the first time-frequency resource.

S350: The second communication apparatus constructs an $i^{th}$ piece of subdata $Y_i'$ based on the first compressed data $Z_i'$ and the third indication information.

S360: The second communication apparatus sends second resource configuration information and/or third resource configuration information to the first communication apparatus, where the second resource configuration information indicates a second time-frequency resource, and the third resource configuration information indicates a third time-frequency resource. Correspondingly, the first communication apparatus receives the second resource configuration information and/or the third resource configuration information sent by the second communication apparatus.

S370: The first communication apparatus performs data compression on the $i^{th}$ piece of subdata $Y_i$ in the M pieces of subdata, to obtain second compressed data $Z_i''$ and/or third compressed data $Z_i'''$ of the $i^{th}$ piece of subdata.

S380: The first communication apparatus sends the second compressed data $Z_i''$ of the $i^{th}$ piece of subdata to the second communication apparatus on the second time-frequency resource, and/or sends the third compressed data $Z_i'''$ to the second communication apparatus on the third time-frequency resource.

S390: The second communication apparatus updates the constructed $i^{th}$ piece of subdata.

In S310, the first communication apparatus sends the upload request to the second communication apparatus, to request to compress and transmit the first data. The upload request may carry the first indication information, to indicate the data type of the first data and/or a size of the first data.

Optionally, the data type includes point cloud data or AI model data.

Optionally, the upload request may be a status report (status report, SR) or a buffer status report (buffer status report, BSR). For example, the first communication apparatus may implicitly indicate the data type by sending the upload request through the SR, or the first communication apparatus may report the size of the first data by sending the upload request through the BSR.

The second communication apparatus may determine, based on the data type of the first data and/or the size of the first data, a time-frequency resource for transmitting compressed first data. Optionally, if the first data is large, and the first data needs to be transmitted in an incremental transmission manner, the second communication apparatus may first determine the first time-frequency resource (including a first time-frequency resource of first compressed data of each piece of subdata) of the first compressed data (including the first compressed data of each piece of subdata) of the first data.

The second communication apparatus may further determine, based on the data type of the first data, whether interpolation is required in a data construction process.

In S320, the first compressed data may include first compressed data of each piece of the M pieces of subdata, or may be the first compressed data of the $i^{th}$ piece of subdata $Y_i$. Correspondingly, the first time-frequency resource may include a first time-frequency resource for transmitting the first compressed data of each piece of the M pieces of subdata, or may be the first time-frequency resource for transmitting the first compressed data of the $i^{th}$ piece of subdata $Y_i$. This is not limited in this application.

Descriptions of determining the first compressed data $Z_i'$ of the $i^{th}$ piece of subdata $Y_i$ in the foregoing embodiments are also applicable to S330. Details are not described herein again.

Based on any one of the foregoing embodiments, in S330, the first communication apparatus may determine a compression parameter based on the first time-frequency resource, and further perform data compression on the $i^{th}$ piece of subdata $Y_i$ based on the compression parameter, to obtain the first compressed data $Z_i'$. The compression parameter

includes at least one of the following:

>    a first capability threshold;
>    a coding scheme parameter;
>    a quantization precision parameter; and
>    a quantity of columns of subdata.

The coding scheme parameter may indicate a coding scheme for each of a dictionary matrix $D_i$ and a sparse matrix $X_i$ that are of the $i^{th}$ piece of subdata $Y_i$ (or first location indication information and a first element sequence that are of the sparse matrix $X_i$). Optionally, the coding scheme may include scalar quantization, vector quantization, entropy coding, and the like.

The quantization precision parameter may indicate precision of quantizing each piece of data that needs to be quantized in the dictionary matrix $D_i$ and the sparse matrix $X_i$ that are of the $i^{th}$ piece of subdata $Y_i$ (or the first location indication information and the first element sequence that are of the sparse matrix $X_i$). Optionally, in a scalar quantization manner, the compression parameter may further include a quantization range of scalar quantization; and in a vector quantization manner, the compression parameter may further include codebook information corresponding to vector quantization.

Optionally, the first communication apparatus may further determine a sampling precision parameter based on the first time-frequency resource, and the first communication apparatus may determine a side length of a cube based on the sampling precision parameter. Alternatively, the sampling precision parameter may directly indicate the side length of the cube.

Optionally, the first communication apparatus may further determine at least one of a first distance threshold, a second distance threshold, and a third distance threshold based on the first time-frequency resource.

In S340, the third indication information and the first compressed data $Z_i'$ may be sent together on the first time-frequency resource. However, this is not limited in this application. For example, the first indication information may be separately sent, and an execution sequence of sending the second indication information and the first compressed data $Z_i'$ by the first communication apparatus is not limited.

The third indication information is an implementation in which second indication information indicates a related parameter of the first compressed data $Z_i'$. First, the second indication information is described by using an example.

The second indication information indicates at least one of the following:

>    the first capability threshold;
>    the second capability threshold;
>    a proportion of elements that are in the sparse matrix $X_i$ and that have a first capability of expressing the $i^{th}$ piece of subdata $Y_i$;
>    a data loss of the compressed data $Z_i$ relative to the $i^{th}$ piece of subdata $Y_i$;
>    a coding scheme parameter;
>    a quantization precision parameter;
>    a quantity of columns of subdata; and
>    whether location indication information of the sparse matrix $X_i$ is differentiated location indication information.

All of the first capability threshold, the second capability threshold, the proportion of elements that are in the sparse matrix $X_i$ and that have the first capability of expressing the $i^{th}$ piece of subdata $Y_i$, and the data loss of the compressed data $Z_i$ relative to the $i^{th}$ piece of subdata $Y_i$ may be used by the second communication apparatus to determine whether the first data needs to be compressed and transmitted in an incremental transmission manner. Both the coding scheme parameter and the quantization precision parameter may be used by the second communication apparatus to decompress the compressed data $Z_i$. All of the first capability threshold, the second capability threshold, the quantity of columns of subdata, and whether the location indication information of the sparse matrix $X_i$ is the differentiated location indication information may be used by the second communication apparatus to construct data.

Optionally, the second indication information may further include the sampling precision parameter.

Optionally, the second indication information may further include at least one of the first distance threshold, the second distance threshold, and the third distance threshold.

For example, the second indication information may include one or more of fields shown in Table 1.

Table 1

| Sampling precision parameter and distance threshold | Data split indication | Compression manner of location indication information | Whether location indication information is differentiated location indication information | Compression manner of an element sequence | Compression manner of a dictionary matrix | Compression status |
|---|---|---|---|---|---|---|
| | | | | | | |

A compression status is used by the second communication apparatus to determine whether the first data needs to be compressed and transmitted in the incremental transmission manner, and the compression status field may include at least one of the first capability threshold, the second capability threshold, the proportion of elements that are in the sparse matrix $X_i$ and that have the first capability of expressing the $i^{th}$ piece of subdata $Y_i$, and the data loss of the compressed data $Z_i$ relative to the $i^{th}$ piece of subdata $Y_i$.

The data split indication may be the quantity of columns of subdata.

Optionally, in the second indication information shown in Table 1, a compression manner of the location indication information may include (Lempel-Ziv 77, LZ77), and LZ77 is a lossless compression algorithm that is based on a dictionary and a "sliding window" and that is invented by Lempel-Ziv in 1977. (Lempel-Ziv-Markov chain algorithm, LZMA). LZMA is a compression algorithm improved based on LZ77, and features a high compression rate, a high decompression speed, and low memory consumption. The foregoing compression manners are merely examples rather than limitation descriptions. The compression manner of the location indication information may further include any other compression algorithm. Examples are not enumerated.

In some embodiments, the sampling precision parameter and distance threshold field and the data split indication field in Table 1 are both optional fields, and fields other than the sampling precision parameter and distance threshold field and the data split indication field in Table 1 are all mandatory fields.

Based on the foregoing examples of the second indication information, the third indication information may indicate at least one of the following:

the first capability threshold;
the proportion of elements (the elements are replaced with first elements in some embodiments) that are in the sparse matrix $X_i$ and that have the first capability of expressing the $i^{th}$ piece of subdata $Y_i$;
the data loss of the first compressed data $Z_i'$ relative to the $i^{th}$ piece of subdata $Y_i$;
the coding scheme parameter;
the quantization precision parameter;
a quantity of columns of subdata; and
whether the first location indication information of the sparse matrix $X_i$ is differentiated location indication information.

In some embodiments, after constructing the $i^{th}$ piece of subdata $Y_i'$ based on the first compressed data $Z_i'$ and the third indication information, the second communication apparatus may send the second resource configuration information and/or the third resource configuration information based on construction quality of the $i^{th}$ piece of subdata $Yi'$, or based on construction quality of the $i^{th}$ piece of subdata $Y_i'$ and a compression status of the first compressed data $Z_i'$, to perform incremental transmission. For example, the second communication apparatus sends the second resource configuration information and/or the third resource configuration information when the construction quality of the $i^{th}$ piece of subdata $Y_i'$ is poor. The compression status may be indicated by the compression status field. Alternatively, the second communication apparatus may send the second resource configuration information and/or the third resource configuration information based on a compression status of the first compressed data $Z_i'$. For example, when the compression status field indicates that the data loss of the first compressed data $Z_i'$ relative to the $i^{th}$ piece of subdata $Y_i$ exceeds a threshold, the second communication apparatus sends the second resource configuration information and/or the third resource configuration information.

Descriptions of determining the second compressed data $Z_i''$ and the third compressed data $Z_i'''$ of the $i^{th}$ piece of subdata $Y_i$ in the foregoing embodiments are also applicable to S370. Details are not described herein again.

Based on any one of the foregoing embodiments, in S370, the first communication apparatus may determine a compression parameter based on the second time-frequency resource, and further perform data compression on the $i^{th}$ piece of subdata $Y_i$ based on the compression parameter, to obtain the second compressed data $Z_i''$. The compression parameter includes at least one of the following:

the first capability threshold;
the coding scheme parameter;

the quantization precision parameter; and
the quantity of columns of subdata.

Based on any one of the foregoing embodiments, in S370, the first communication apparatus may determine a compression parameter based on the third time-frequency resource, and further perform data compression on the $i^{th}$ piece of subdata $Y_i$ based on the compression parameter, to obtain the third compressed data $Z_i'''$. The compression parameter includes at least one of the following:

the first capability threshold;
the second capability threshold;
the coding scheme parameter;
the quantization precision parameter; and
the quantity of columns of subdata.

Optionally, the first communication apparatus may send fourth indication information to the second communication apparatus, where the fourth indication information is an implementation in which the second indication information indicates a related parameter of the second compressed data $Z_i''$. The fourth indication information may indicate at least one of the following:

the first capability threshold;
the proportion of elements that are in the sparse matrix $X_i$ and that have the first capability of expressing the $i^{th}$ piece of subdata $Y_i$;
the data loss of the compressed data $Z_i$ relative to the $i^{th}$ piece of subdata $Y_i$;
the coding scheme parameter;
the quantization precision parameter;
the quantity of columns of subdata; and
whether second location indication information of the sparse matrix $X_i$ is differentiated location indication information.

Optionally, the first communication apparatus may send fifth indication information to the second communication apparatus, where the fifth indication information is an implementation in which the second indication information indicates a related parameter of the third compressed data $Z_i''$. The fifth indication information may indicate at least one of the following:

the first capability threshold;
the second capability threshold;
the coding scheme parameter;
the quantization precision parameter;
the quantity of columns of subdata; and
whether the location indication information of the sparse matrix $X_i$ is differentiated location indication information.

Both S380 and S390 are described in the foregoing embodiments. Details are not described herein again.

In some implementation scenarios of this embodiment of this application, at least two of the first compressed data, the second compressed data, and the third compressed data may be sent together. The second communication apparatus may send resource configuration information respectively corresponding to at least two pieces of compressed data together. In this case, at least two of the first resource configuration information, the second resource configuration information, and the third resource configuration information that are sent together may be included in the resource configuration information.

Therefore, in this embodiment of this application, the first communication apparatus splits the to-be-transmitted first data into the M pieces of subdata, decomposes the $i^{th}$ piece of subdata $Y_i$ in the M pieces of subdata into the dictionary matrix $D_i$ and the sparse matrix $X_i$, further performs data compression based on the dictionary matrix $D_i$ and the sparse matrix $X_i$, to obtain the compressed data $Z_i$ of the $i^{th}$ piece of subdata $Y_i$, and then sends the compressed data $Z_i$ of the $i^{th}$ piece of subdata $Y_i$ to the second communication apparatus. The $i^{th}$ piece of subdata $Y_i$ is expressed by using the sparse matrix $X_i$ based on the dictionary matrix $D_i$, so that in a communication scenario in which a large amount of data is transmitted, effective and reliable data compression and transmission can be implemented on the first data with a large data amount.

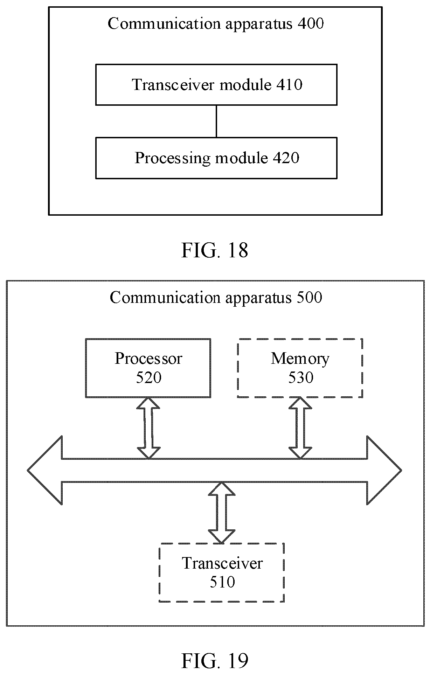

FIG. 18 is a block diagram of a communication apparatus according to an embodiment of this application. A communication apparatus 400 may be a terminal or network device, may be an apparatus in a terminal device or a network device, or may be an apparatus that can be used together with a terminal device or a network device. In a possible implementation, the communication apparatus 400 may include modules or units that one-to-one correspond to the methods/operations/steps/actions performed by the first communication apparatus or the second communication apparatus in the foregoing method embodiments, and the units may be implemented by a hardware circuit, software, or a combination of a hardware circuit and software. In a possible implementation, as shown in FIG. 18, the apparatus 400 may include a transceiver module 410 and a processing module 420.

Optionally, the communication apparatus 400 may correspond to the first communication apparatus in the foregoing method embodiments.

When the communication apparatus 400 is configured to perform the method on a first communication apparatus side, the processing module 420 may be configured to decompose an $i^{th}$ piece of subdata $Y_i$ in M pieces of subdata into a dictionary matrix $D_i$ and a sparse matrix $X_i$, where the dictionary matrix $D_i$ includes a feature of the $i^{th}$ piece of subdata $Y_i$, the sparse matrix $X_i$ is used to express the $i^{th}$ piece of subdata $Y_i$ based on the dictionary matrix $D_i$, the M pieces of subdata are included in to-be-transmitted first data, M is an integer greater than or equal to 1, and i is an integer greater than or equal to 1 and less than or equal to M; the processing module 420 may be further configured to perform data compression based on the dictionary matrix $D_i$ and the sparse matrix $X_i$, to obtain compressed data $Z_i$ of the $i^{th}$ piece of subdata $Y_i$; and the transceiver module 410 may be configured to send the compressed data $Z_i$ to a second communication apparatus.

It should be understood that specific processes performed by the modules are described in detail in the foregoing method embodiments. For brevity, details are not described herein again.

Optionally, the communication apparatus 400 may correspond to the second communication apparatus in the foregoing method embodiments.

When the communication apparatus 400 is configured to perform the method on a second communication apparatus side, the transceiver module 410 may be configured to receive compressed data $Z_i$ of an $i^{th}$ piece of subdata $Y_i$ in M pieces of subdata sent by a first communication apparatus, where the M pieces of subdata are included in first data, M is an integer greater than or equal to 1, and i is an integer greater than or equal to 1 and less than or equal to M; the processing module 420 may be configured to determine a dictionary matrix $D_i'$ and a sparse matrix $X_i'$ based on the compressed data $Z_i$, where the dictionary matrix $D_i'$ includes a feature of the $i^{th}$ piece of subdata $Y_i$, and the sparse matrix $X_i'$ is used to express the $i^{th}$ piece of subdata $Y_i$ based on the dictionary matrix $D_i'$; and the processing module 420 is further configured to construct an $i^{th}$ piece of subdata $Y_i'$ in M pieces of subdata of second data based on the dictionary matrix $D_i'$ and the sparse matrix $X_i'$.

It should be understood that specific processes performed by the modules are described in detail in the foregoing method embodiments. For brevity, details are not described herein again.

The transceiver module 410 in the communication apparatus 400 may be implemented by using a transceiver, for example, may correspond to a transceiver 520 in a communication apparatus 500 shown in FIG. 19. The processing module 420 in the communication apparatus 400 may be implemented by using at least one processor, for example, may correspond to a processor 510 in the communication apparatus 500 shown in FIG. 19.

When the communication apparatus 400 is a chip or a chip system configured in a communication device (for example, a terminal device or a network device), the transceiver module 410 in the communication apparatus 400 may be implemented by using an input/output interface, a circuit, or the like, and the processing module 420 in the communication apparatus 400 may be implemented by using a processor, a microprocessor, an integrated circuit, or the like integrated on the chip or the chip system.

FIG. 19 is another block diagram of a communication apparatus according to an embodiment of this application. As shown in FIG. 19, the communication apparatus 500 may include the processor 510. The processor 510 may be configured to perform the method performed by the first communication apparatus or the second communication apparatus in the foregoing method embodiments.

In some possible implementations, the communication apparatus 500 may include the transceiver 520. The transceiver 520 and the processor 510 may communicate with each other through an internal connection path. The processor 510 may control the transceiver 520 to send a signal and/or receive a signal.

In some possible implementations, the communication apparatus 500 may include a memory 530. The memory 530 and the processor 510 may communicate with each other through an internal connection path. The memory 530 and the processor 510 may be integrated together, or may be disposed separately. The memory 530 may alternatively be a memory outside the apparatus. The memory 530 is configured to store instructions, and the processor 510 is configured to execute the instructions stored in the memory 530, to perform the methods in the foregoing method embodiments.

It should be understood that the communication apparatus 500 may correspond to the terminal device or the network device in the foregoing method embodiments, and may be configured to perform steps and/or procedures performed by the first communication apparatus or the second communication apparatus in the foregoing method embodiments. Optionally, the memory 530 may include a read-only memory and a random access memory, and may provide instructions and data for the processor. A part of the memory may further include a non-volatile random access memory. The memory 530 may be an independent component, or may be integrated into the processor 510. The processor 510 may be configured to execute the instructions stored in the memory 530, and when the processor 510 executes the instructions stored in the memory, the processor 510 is configured to perform steps and/or procedures corresponding to the terminal device or the network device in the foregoing method embodiments.

Optionally, the communication apparatus 500 is the first communication apparatus in the foregoing embodiments.

Optionally, the communication apparatus 500 is the second communication apparatus in the foregoing embodiments.

The transceiver 520 may include a transmitter and a receiver. The transceiver 520 may further include one or more antennas. The processor 510, the memory 530, and the transceiver 520 may be components integrated on different chips. For example, the processor 510 and the memory 530 may be integrated in a baseband chip, and the transceiver 520 may be integrated in a radio frequency chip. The processor 510, the memory 530, and the transceiver 520 may alternatively be components integrated on a same chip. This is not limited in this application.

Optionally, the communication apparatus 500 is a component configured in a terminal device, for example, a chip or a chip system.

Optionally, the communication apparatus 500 is a component configured in a network device, for example, a chip or a chip system.

The transceiver 520 may alternatively be a communication interface, for example, an input/output interface or a circuit. The transceiver 520, the processor 510, and the memory 530 may be integrated in a same chip, for example, integrated in a baseband chip.

This application further provides a processing apparatus, including at least one processor. The at least one processor enables, by running a computer program or by using a logic circuit, the processing apparatus to perform the methods performed by the first communication apparatus or the second communication apparatus in the foregoing method embodiments. The processing apparatus may further include a memory, and the memory is configured to store the computer program.

Embodiments of this application further provide a processing apparatus, including a processor and an input/output interface. The input/output interface is coupled to the processor. The input/output interface is configured to input and/or output information. The information includes at least one of instructions and data. The processor is configured to execute a computer program, to enable the processing apparatus to perform the methods performed by the first communication apparatus or the second communication apparatus in the foregoing method embodiments.

Embodiments of this application further provide a processing apparatus, including a processor and a memory. The memory is configured to store a computer program, and the processor is configured to: invoke the computer program from the memory, and run the computer program, to enable the processing apparatus to perform the methods performed by the first communication apparatus or the second communication apparatus in the foregoing method embodiments.

It should be understood that the processing apparatus may be one or more chips. For example, the processing apparatus may be a field programmable gate array (field programmable gate array, FPGA), an application-specific integrated chip (application-specific integrated circuit, ASIC), a system on chip (system on chip, SoC), a central processing unit (central processing unit, CPU), a network processor (network processor, NP), a digital signal processor (digital signal processor, DSP), a micro controller unit (micro controller unit, MCU), a programmable controller (programmable logic device, PLD), or another integrated chip.

In an implementation process, steps in the foregoing methods may be implemented by using a hardware integrated logic circuit in the processor or by using instructions in a form of software. Steps in the methods disclosed with reference to embodiments of this application may be directly performed and completed by a hardware processor, or may be performed and completed by using a combination of hardware and a software module in the processor. The software module may be located in a mature storage medium in the art, such as a random access memory, a flash memory, a read-only memory, a programmable read-only memory, an electrically erasable programmable memory, or a register. The storage medium is located in the memory, and the processor reads information in the memory and completes the steps in the foregoing methods in combination with hardware of the processor. To avoid repetition, details are not described herein again.

It should be noted that the processor in embodiments of this application may be an integrated circuit chip and has a signal processing capability. In an implementation process, steps in the foregoing method embodiments may be implemented by using a hardware integrated logic circuit in the processor or by using instructions in a form of software. The processor may be a general-purpose processor, a digital signal processor (DSP), an application-specific integrated circuit (ASIC), a field programmable gate array (FPGA) or another programmable logic device, a discrete gate or transistor logic device, or a discrete hardware component, and may implement or perform the methods, the steps, and the logical block diagrams disclosed in embodiments of this application. The general-purpose processor may be a microprocessor, or the processor may be any conventional processor or the like. The steps in the methods disclosed with reference to embodiments of this application may be directly performed and completed by a hardware decoding processor, or may be performed and completed by using a combination of hardware and a software module in a decoding processor. The software module may be located in a mature storage medium in the art, such as a random access memory, a flash memory, a read-only memory, a programmable read-only memory, an electrically erasable programmable memory, or a register. The storage medium is located in the memory, and the processor reads information in the memory and completes the steps in the foregoing methods in combination with hardware of the processor.

It may be understood that the memory in embodiments of this application may be a volatile memory or a non-volatile memory, or may include both a volatile memory and a non-volatile memory. The non-volatile memory may be a read-only memory (read-only memory, ROM), a programmable read-only memory (programmable ROM, PROM), an erasable programmable read-only memory (erasable PROM, EPROM), an electrically erasable programmable read-only memory (electrically EPROM, EEPROM), or a flash memory. The volatile memory may be a random access memory (random access memory, RAM) and is used as an external cache. By way of example but not limitation, many forms of RAMs may be used, for example, a static random access memory (static RAM, SRAM), a dynamic random access memory (dynamic RAM, DRAM), a synchronous dynamic random access memory (synchronous DRAM, SDRAM), a double data rate synchronous dynamic random access memory (double data rate SDRAM, DDR SDRAM), an enhanced synchronous dynamic random access memory (enhanced SDRAM, ESDRAM), a synchlink dynamic random access memory (synchlink DRAM, SLDRAM), and a direct rambus random access memory (direct rambus RAM, DR RAM). It should be noted that the memory in the system and the method described in this specification is intended to include but is not limited to these memories and any memory of another proper type.

According to the methods provided in embodiments of this application, this application further provides a computer program product. The computer program product includes a computer program or a group of instructions, and when the computer program or the group of instructions are run on a computer, the computer is enabled to perform the methods performed by the first communication apparatus or the second communication apparatus in the foregoing method embodiments.

According to the methods provided in embodiments of this application, this application further provides a computer-readable storage medium. The computer-readable storage medium stores a program, and when the program is run on a computer, the computer is enabled to perform the methods performed by the first communication apparatus or the second communication apparatus in the foregoing method embodiments.

According to the methods provided in embodiments of this application, this application further provides a communication system. The communication system may include the foregoing first communication apparatus or second communication apparatus.

Terms such as "component", "module", and "system" used in this specification indicate computer-related entities, hardware, firmware, combinations of hardware and software, software, or software being executed. For example, a component may be, but is not limited to, a process that runs on a processor, a processor, an object, an executable file, an execution thread, a program, and/or a computer. As shown in the figure, both an application running on a computing device and the computing device may be components. One or more components may reside in a process and/or an execution thread, and a component may be located on one computer and/or distributed between two or more computers. In addition, these components may be executed by using various computer-readable media that store various data structures. For example, these components may communicate by using a local and/or remote process and based on, for example, a signal having one or more data packets (for example, data from two components interacting with another component in a local system, a distributed system, and/or across a network such as the internet interacting with another system by using the signal).

A person of ordinary skill in the art may be aware that, in combination with the examples described in embodiments disclosed in this specification, units and algorithm steps may be implemented by electronic hardware or a combination of computer software and electronic hardware. Whether the functions are performed by hardware or software depends on particular applications and design constraint conditions of the technical solutions. A person skilled in the art may use different methods to implement the described functions for each particular application, but it should not be considered that the implementation goes beyond the scope of this application.

It may be clearly understood by a person skilled in the art that, for the purpose of convenient and brief description, for a detailed working process of the foregoing system, apparatus, and unit, refer to a corresponding process in the foregoing method embodiments. Details are not described herein again.

In the several embodiments provided in this application, it should be understood that the disclosed system, apparatus, and method may be implemented in other manners. For example, the described apparatus embodiment is merely an example. For example, division into the units is merely logical function division and may be other division in actual implementation. For example, a plurality of units or components may be combined or integrated into another system, or some features may be ignored or not performed. In addition, the displayed or discussed mutual couplings or direct couplings or communication connections may be implemented by using some interfaces, and the indirect couplings or communication connections between the apparatuses or units may be implemented in electronic, mechanical, or other forms.

The units described as separate parts may or may not be physically separate, and parts displayed as units may or may not be physical units, may be located in one location, or may be distributed on a plurality of network units. Some or all of the units may be selected based on actual requirements to achieve the objectives of the solutions of embodiments.

In addition, functional units in embodiments of this application may be integrated into one processing unit, each of the units may exist alone physically, or two or more units are integrated into one unit.

When the functions are implemented in a form of a software functional unit and sold or used as an independent product, the functions may be stored in a computer-readable storage medium. Based on such an understanding, the technical solutions of this application essentially, the part contributing to the conventional technology, or some of the technical solutions may be implemented in a form of a software product. The computer software product is stored in a storage medium and includes several instructions for instructing a computer device (which may be a personal computer, a server, a network device, or the like) to perform all or some of the steps of the methods described in embodiments of this application. The storage medium includes any medium that can store program code, for example, a USB flash drive, a removable hard disk, a ROM, a RAM, a magnetic disk, or an optical disc.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

**Claims**

1. A data compression and transmission method, comprising:

    decomposing, by a first communication apparatus, an $i^{th}$ piece of subdata $Y_i$ in M pieces of subdata into a dictionary matrix $D_i$ and a sparse matrix $X_i$, wherein the dictionary matrix $D_i$ comprises a feature of the $i^{th}$ piece of subdata $Y_i$, the sparse matrix $X_i$ is used to express the $i^{th}$ piece of subdata $Y_i$ based on the dictionary matrix $D_i$, the M pieces of subdata are comprised in to-be-transmitted first data, M is an integer greater than or equal to 1, and i is an integer greater than or equal to 1 and less than or equal to M;
    performing, by the first communication apparatus, data compression based on the dictionary matrix $D_i$ and the sparse matrix $X_i$, to obtain compressed data $Z_i$ of the $i^{th}$ piece of subdata $Y_i$; and
    sending, by the first communication apparatus, the compressed data $Z_i$ to a second communication apparatus.

2. The method according to claim 1, wherein that the first communication apparatus obtains compressed data $Z_i$ of the $i^{th}$ piece of subdata $Y_i$ comprises:

    determining, by the first communication apparatus, first location indication information and a first element sequence that are of the sparse matrix $X_i$, wherein
    the first location indication information indicates whether an element in the sparse matrix $X_i$ has a first capability of expressing the $i^{th}$ piece of subdata $Y_i$, and the first element sequence comprises an element that has the first capability of expressing the $i^{th}$ piece of subdata $Y_i$; or
    the first location indication information indicates whether a first element in the sparse matrix $X_i$ has a first capability of expressing the $i^{th}$ piece of subdata $Y_i$, elements in the sparse matrix $X_i$ comprise the first element, and the first element sequence comprises an element that has the first capability of expressing the $i^{th}$ piece of subdata $Y_i$; and
    performing, by the first communication apparatus, data compression on the dictionary matrix $D_i$, and the first location indication information and the first element sequence that are of the sparse matrix $X_i$, to obtain first compressed data $Z_i'$ of the $i^{th}$ piece of subdata $Y_i$.

3. The method according to claim 2, wherein the first location indication information is a first bitmap; and

    bits in the first bitmap one-to-one correspond to the elements in the sparse matrix $X_i$, and a bit in the first bitmap indicates whether a corresponding element in the sparse matrix $X_i$ has the first capability of expressing the $i^{th}$ piece of subdata $Y_i$; or
    bits in the first bitmap one-to-one correspond to first elements in the sparse matrix $X_i$, and a bit in the first bitmap indicates whether a corresponding first element in the sparse matrix $X_i$ has the first capability of expressing the $i^{th}$ piece of subdata $Y_i$.

4. The method according to claim 2 or 3, wherein the determining, by the first communication apparatus, first location indication information and a first element sequence that are of the sparse matrix $X_i$ comprises:

    determining, by the first communication apparatus, whether each element in the sparse matrix $X_i$ has the first

capability of expressing the $i^{th}$ piece of subdata $Y_i$ based on the element and a first capability threshold; and determining, by the first communication apparatus, the first location indication information and the first element sequence based on whether each element in the sparse matrix $X_i$ has the first capability of expressing the $i^{th}$ piece of subdata $Y_i$.

5. The method according to any one of claims 2 to 4, wherein the first location indication information of the sparse matrix $X_i$ is differentiated location indication information obtained by performing exclusive OR on first location indication information of the $i^{th}$ piece of subdata $Y_i$ and first location indication information of an $(i-1)^{th}$ piece of subdata $Y_{i-1}$; and using the differentiated location indication information as the first location indication information of the sparse matrix $X_i$.

6. The method according to claim 5, wherein a first proportion of the differentiated location indication information is greater than or equal to a proportion threshold, the first proportion is a proportion of a quantity of bits with a first value or a second value in bits of the differentiated location indication information to a quantity of all the bits of the differentiated location indication information, the first value indicates that a corresponding element in the sparse matrix $X_i$ has the first capability of expressing the $i^{th}$ piece of subdata $Y_i$, and the second value indicates that a corresponding element in the sparse matrix $X_i$ does not have the first capability of expressing the $i^{th}$ piece of subdata $Y_i$.

7. The method according to any one of claims 2 to 6, wherein the first location indication information indicates whether the first element in the sparse matrix $X_i$ has the first capability of expressing the $i^{th}$ piece of subdata $Y_i$, the elements in the sparse matrix $X_i$ comprise a second element, and the second element is different from the first element; and the method further comprises:

determining, by the first communication apparatus, second location indication information and a second element sequence that are of the sparse matrix $X_i$, wherein the second location indication information indicates whether a second element in the sparse matrix $X_i$ has the first capability of expressing the $i^{th}$ piece of subdata $Y_i$, and the second element sequence comprises a second element that has the first capability of expressing the $i^{th}$ piece of subdata $Y_i$; and
performing, by the first communication apparatus, data compression on the second location indication information and the second element sequence, to obtain second compressed data $Z_i''$ of the $i^{th}$ piece of subdata $Y_i$, wherein the second compressed data $Z_i''$ is different from the first compressed data $Z_i'$.

8. The method according to any one of claims 2 to 7, wherein the method further comprises:

determining, by the first communication apparatus, third location indication information and a third element sequence that are of the sparse matrix $X_i$, wherein the third location indication information indicates whether an element in the sparse matrix $X_i$ has a second capability of expressing the $i^{th}$ piece of subdata $Y_i$, and the third element sequence comprises an element that has the second capability of expressing the $i^{th}$ piece of subdata $Y_i$;
performing, by the first communication apparatus, data compression on the third location indication information and the third element sequence that are of the sparse matrix $X_i$, to obtain third compressed data $Z_i'''$ of the $i^{th}$ piece of subdata $Y_i$; and
sending, by the first communication apparatus, the third compressed data $Z_i'''$ to the second communication apparatus.

9. The method according to claim 8, wherein the determining, by the first communication apparatus, third location indication information and a third element sequence that are of the sparse matrix $X_i$ comprises:

determining, by the first communication apparatus, whether each element in the sparse matrix $X_i$ has the second capability of expressing the $i^{th}$ piece of subdata $Y_i$ based on the element, the first capability threshold, and a second capability threshold; and
determining, by the first communication apparatus, the third location indication information and the third element sequence based on whether each element in the sparse matrix $X_i$ has the second capability of expressing the $i^{th}$ piece of subdata $Y_i$.

10. The method according to any one of claims 2 to 7, wherein the method further comprises:

determining, by the first communication apparatus, a third element sequence of the sparse matrix $X_i$, wherein the third element sequence comprises N elements in the sparse matrix $X_i$ other than an element comprised in the first element sequence, and N is a positive integer;

performing, by the first communication apparatus, data compression on the third element sequence, to obtain third compressed data $Z_i'''$ of the $i^{th}$ piece of subdata $Y_i$; and

sending, by the first communication apparatus, the third compressed data $Z_i'''$ to the second communication apparatus.

11. The method according to claim 10, wherein the N elements are elements in preset rows/columns in the sparse matrix $X_i$.

12. The method according to any one of claims 1 to 11, wherein a quantity of columns in matrices formed by the M pieces of subdata is the same.

13. The method according to any one of claims 1 to 12, wherein the method further comprises:

determining, by the first communication apparatus, a compression parameter based on a time-frequency resource of the first data; and

performing, by the first communication apparatus, data compression on the $i^{th}$ piece of subdata $Y_i$ based on the compression parameter, to obtain the compressed data $Z_i$, wherein

the compression parameter comprises at least one of the following:

the first capability threshold, wherein the first capability threshold is used to determine whether an element in the sparse matrix $X_i$ has the first capability of expressing the $i^{th}$ piece of subdata $Y_i$;

the second capability threshold, wherein the second capability threshold is used to determine whether an element in the sparse matrix $X_i$ has the second capability of expressing the $i^{th}$ piece of subdata $Y_i$;

a coding scheme parameter;

a quantization precision parameter; and

a quantity of columns of subdata.

14. The method according to any one of claims 1 to 13, wherein the method further comprises:

sending, by the first communication apparatus, second indication information to the second communication apparatus, wherein the second indication information indicates at least one of the following:

the first capability threshold, wherein the first capability threshold is used to determine whether an element in the sparse matrix $X_i$ has the first capability of expressing the $i^{th}$ piece of subdata $Y_i$;

the second capability threshold, wherein the second capability threshold is used to determine whether an element in the sparse matrix $X_i$ has the second capability of expressing the $i^{th}$ piece of subdata $Y_i$;

a proportion of elements that are in the sparse matrix $X_i$ and that have the first capability of expressing the $i^{th}$ piece of subdata $Y_i$;

a data loss of the compressed data $Z_i$ relative to the $i^{th}$ piece of subdata $Y_i$;

a coding scheme parameter;

a quantization precision parameter;

a quantity of columns of subdata; and

whether location indication information of the sparse matrix $X_i$ is differentiated location indication information.

15. A data compression and transmission method, comprising:

receiving, by a second communication apparatus, compressed data $Z_i$ of an $i^{th}$ piece of subdata $Y_i$ in M pieces of subdata sent by a first communication apparatus, wherein the M pieces of subdata are comprised in first data, M is an integer greater than or equal to 1, and i is an integer greater than or equal to 1 and less than or equal to M;

determining, by the second communication apparatus, a dictionary matrix $D_i'$ and a sparse matrix $X_i'$ based on the compressed data $Z_i$, wherein the dictionary matrix $D_i'$ comprises a feature of the $i^{th}$ piece of subdata $Y_i$, and the sparse matrix $X_i'$ is used to express the $i^{th}$ piece of subdata $Y_i$ based on the dictionary matrix $D_i'$; and

constructing, by the second communication apparatus, an $i^{th}$ piece of subdata $Y_i'$ in M pieces of subdata of second data based on the dictionary matrix $D_i'$ and the sparse matrix $X_i'$.

16. The method according to claim 15, wherein the compressed data $Z_i$ comprises first compressed data $Z_i'$; and the determining, by the second communication apparatus, a dictionary matrix $D_i'$ and a sparse matrix $X_i'$ based on the compressed data $Z_i$ comprises:

decompressing, by the second communication apparatus, the first compressed data $Z_i'$ to obtain the dictionary matrix $D_i'$, and first location indication information and a first element sequence that are of the sparse matrix $X_i'$, wherein

the first location indication information indicates whether an element in the sparse matrix $X_i'$ has a first capability of expressing the $i^{th}$ piece of subdata $Y_i$ in the M pieces of subdata of the first data, and the first element sequence comprises an element that has the first capability of expressing the $i^{th}$ piece of subdata $Y_i$; or

the first location indication information indicates whether a first element in the sparse matrix $X_i'$ has a first capability of expressing the $i^{th}$ piece of subdata $Y_i$, elements in the sparse matrix $X_i'$ comprise the first element, and the first element sequence comprises an element that has the first capability of expressing the $i^{th}$ piece of subdata $Y_i$; and

determining, by the second communication apparatus, the sparse matrix $X_i'$ based on the first location indication information and the first element sequence that are of the sparse matrix $X_i'$.

17. The method according to claim 16, wherein the first location information is a first bitmap; and

bits in the first bitmap one-to-one correspond to the elements in the sparse matrix $X_i'$, and a bit in the first bitmap indicates whether a corresponding element in the sparse matrix $X_i'$ has the first capability of expressing the $i^{th}$ piece of subdata $Y_i$; or

bits in the first bitmap one-to-one correspond to first elements in the sparse matrix $X_i'$, and a bit in the first bitmap indicates whether a corresponding first element in the sparse matrix $X_i'$ has the first capability of expressing the $i^{th}$ piece of subdata $Y_i$.

18. The method according to claim 16 or 17, wherein the first location indication information of the sparse matrix $X_i'$ is differentiated location indication information obtained by performing exclusive OR on first location indication information of the $i^{th}$ piece of subdata and first location indication information of an $(i-1)^{th}$ piece of subdata.

19. The method according to any one of claims 16 to 18, wherein the compressed data $Z_i$ further comprises second compressed data $Z_i''$, and the first location indication information indicates whether the first element in the sparse matrix $X_i'$ has the first capability of expressing the $i^{th}$ piece of subdata $Y_i$; and the determining, by the second communication apparatus, a dictionary matrix $D_i'$ and a sparse matrix $X_i'$ based on the first compressed data $Z_i$ comprises:

decompressing, by the second communication apparatus, the second compressed data $Z_i''$, to obtain second location indication information and a second element sequence that are of the sparse matrix $X_i'$, wherein the second location indication information indicates whether a second element in the sparse matrix $X_i'$ has the first capability of expressing the $i^{th}$ piece of subdata $Y_i$, and the second element sequence comprises a second element that has the first capability of expressing the $i^{th}$ piece of subdata $Y_i$; and

determining, by the second communication apparatus, the sparse matrix $X_i'$ based on the first location indication information, the first element sequence, the second location indication information, and the second element sequence that are of the sparse matrix $X_i'$.

20. The method according to claim 19, wherein the compressed data $Z_i$ further comprises third compressed data $Z_i'''$; and the determining, by the second communication apparatus, a dictionary matrix $D_i'$ and a sparse matrix $X_i'$ based on the first compressed data $Z_i$ comprises:

decompressing, by the second communication apparatus, the third compressed data $Z_i'''$, to obtain third location indication information and a third element sequence that are of the sparse matrix $X_i'$, wherein the third location indication information indicates whether an element in the sparse matrix $X_i'$ has a second capability of expressing the $i^{th}$ piece of subdata $Y_i$, and the second element sequence comprises an element that has the second capability of expressing the $i^{th}$ piece of subdata $Y_i$; and

determining, by the second communication apparatus, the sparse matrix $X_i'$ based on the third location indication information and the third element sequence that are of the sparse matrix $X_i'$, and at least one of the following:

the first location indication information and the first element sequence that are of the sparse matrix $X_i'$; and

the second location indication information and the second element sequence that are of the sparse matrix $X_i'$.

21. The method according to claim 19, wherein the compressed data $Z_i$ further comprises third compressed data $Z_i'''$; and the determining, by the second communication apparatus, a dictionary matrix $D_i'$ and a sparse matrix $X_i'$ based on the

first compressed data $Z_i$ comprises:

decompressing, by the second communication apparatus, the third compressed data $Z_i'''$, to obtain a third element sequence of the sparse matrix $X_i'$, wherein the third element sequence comprises N elements in the sparse matrix $X_i'$ other than elements comprised in the first element sequence and/or the second element sequence, and N is a positive integer; and

determining, by the second communication apparatus, the sparse matrix $X_i'$ based on the third element sequence of the sparse matrix $X_i'$ and at least one of the following:

the first location indication information and the first element sequence that are of the sparse matrix $X_i'$; and

the second location indication information and the second element sequence that are of the sparse matrix $X_i'$.

22. The method according to claim 21, wherein the N elements are elements in preset rows/columns in the sparse matrix $X_i$.

23. The method according to any one of claims 15 to 22, wherein a quantity of columns in matrices formed by the M pieces of subdata is the same.

24. The method according to any one of claims 15 to 23, wherein the method further comprises:

receiving, by the second communication apparatus, second indication information sent by the first communication apparatus, wherein the second indication information indicates at least one of the following:

a first capability threshold, wherein the first capability threshold is used to determine whether an element in the sparse matrix $X_i$ has the first capability of expressing the $i^{th}$ piece of subdata $Y_i$;

a second capability threshold, wherein the second capability threshold is used to determine whether an element in the sparse matrix $X_i$ has the second capability of expressing the $i^{th}$ piece of subdata $Y_i$;

a proportion of elements that are in the sparse matrix $X_i$ and that have the first capability of expressing the $i^{th}$ piece of subdata $Y_i$;

a data loss of the compressed data $Z_i$ relative to the $i^{th}$ piece of subdata $Y_i$ in the M pieces of subdata of the first data;

a coding scheme parameter;

a quantization precision parameter;

a quantity of columns of subdata; and

whether a bitmap of the sparse matrix $X_i$ is a differentiated bitmap.

25. A communication apparatus, comprising a module configured to perform the method according to any one of claims 1 to 14 or a module configured to perform the method according to any one of claims 15 to 24.

26. A communication apparatus, comprising a processor, wherein the processor is configured to perform the method according to any one of claims 1 to 24 by running a computer program or by using a logic circuit.

27. The apparatus according to claim 26, further comprising a memory, and the memory is configured to store the computer program.

28. The apparatus according to claim 26 or 27, further comprising a communication interface, and the communication interface is configured to input and/or output a signal.

29. A communication system, comprising a first communication apparatus configured to perform the method according to any one of claims 1 to 14 and a second communication apparatus configured to perform the method according to any one of claims 15 to 24.

30. A computer-readable storage medium, configured to store computer program instructions, wherein the computer program enables a computer to perform the method according to any one of claims 1 to 24.

31. A computer program product, comprising computer program instructions, wherein the computer program instructions enable a computer to perform the method according to any one of claims 1 to 24.

100

FIG. 1

FIG. 2

200

| First communication apparatus | | Second communication apparatus |
|---|---|---|

S210: Decompose an $i^{th}$ piece of subdata $Y_i$ in M pieces of subdata into a dictionary matrix $D_i$ and a sparse matrix $X_i$, where the dictionary matrix $D_i$ includes a feature of the $i^{th}$ piece of subdata $Y_i$, the sparse matrix $X_i$ is used to express the $i^{th}$ piece of subdata $Y_i$ based on the dictionary matrix $D_i$, and the M pieces of subdata are included in to-be-transmitted first data

S220: Perform data compression based on the dictionary matrix $D_i$ and the sparse matrix $X_i$, to obtain compressed data $Z_i$ of the $i^{th}$ piece of subdata $Y_i$

S230: Send the compressed data $Z_i$

S240: Determine a dictionary matrix $D_i'$ and a sparse matrix $X_i'$ based on the compressed data $Z_i$, where the dictionary matrix $D_i'$ includes the feature of the $i^{th}$ piece of subdata $Y_i$, and the sparse matrix $X_i'$ is used to express the $i^{th}$ piece of subdata $Y_i$ based on the dictionary matrix $D_i'$

S250: Construct an $i^{th}$ piece of subdata $Y_i'$ in M pieces of subdata of second data based on the dictionary matrix $D_i'$ and the sparse matrix $X_i'$

FIG. 3

FIG. 4

$$Y$$

$$\mathbf{y_1} \quad \mathbf{y_K} \quad \mathbf{y_{K+1}} \quad \mathbf{y_{2K}} \quad \mathbf{y_{Q-K+1}} \quad \mathbf{y_Q}$$

$$\mathbf{Y_1} \qquad \mathbf{Y_2} \qquad \mathbf{Y_{Q/K}}$$

FIG. 5

K

$\mathbf{Y}_1$ | | | ... | | | } L

$\mathbf{y}_1$ ... $\mathbf{y}_K$

Element having
a capability of
expressing $Y_1$

L

$\mathbf{D}_1$ | | ... | } L

K

$\mathbf{X}_1$

L

$\mathbf{x}_1$ $\mathbf{x}_2$ $\mathbf{x}_3$ $\mathbf{x}_4$ ... $\mathbf{x}_K$

K

| 1 | 0 | 0 | 0 | 0 | 0 | 0 | 0 | | 0 | 0 | 0 |
|---|---|---|---|---|---|---|---| |---|---|---|
| 0 | 1 | 1 | 0 | 1 | 0 | 0 | 1 | | 1 | 0 | 0 |
| ... | ... | ... | ... | ... | ... | ... | ... | ... | ... | ... | ... |
| 0 | 0 | 0 | 0 | 1 | 1 | 1 | 0 | | 0 | 0 | 1 |
| 0 | 0 | 0 | 0 | 0 | 0 | 0 | 0 | | 0 | 1 | 0 |

} L

Location
indication
information

Compressed
data of $Y_1$

Element sequence

FIG. 6

FIG. 7

FIG. 8

FIG. 9

EP 4 586 566 A1

FIG. 10

FIG. 11

| First compressed data Zi' | First location indication information | First element sequence | Dictionary matrix |
|---|---|---|---|

$\longleftarrow$ TB $\longrightarrow$

| Second compressed data $Z_i''$ | Second location indication information | Second element sequence |
|---|---|---|

$\longleftarrow$ TB $\longrightarrow$

FIG. 12

First location indication information of $Y_1$

| 0 | 1 | 1 | 1 | 1 |
|---|---|---|---|---|
| 0 | 1 | 1 | 1 | 1 |
| 0 | 0 | 0 | 0 | 1 |

Differentiated location indication information

| 1 | 0 | 0 | 0 | 0 |
|---|---|---|---|---|
| 0 | 1 | 0 | 0 | 1 |
| 0 | 0 | 0 | 0 | 1 |

XOR

First location indication information of $Y_2$

| 1 | 1 | 1 | 1 | 1 |
|---|---|---|---|---|
| 0 | 0 | 1 | 1 | 0 |
| 0 | 0 | 0 | 0 | 0 |

FIG. 13

Spatial point

Geometric center of a cube

Spatial point

Sampling point

FIG. 14

FIG. 15

FIG. 16

300

```
┌─────────────────────────┐                              ┌─────────────────────────┐
│  First communication    │                              │       Second            │
│       apparatus         │                              │   communication         │
│                         │                              │      apparatus          │
└─────────────────────────┘                              └─────────────────────────┘
```

S310: Send an upload request, where the upload request carries first indication information, where the first indication information indicates a data type of first data

S320: Send first resource configuration information, where the first resource configuration information indicates a first time-frequency resource for transmitting first compressed data

S330: Perform data compression on an $i^{th}$ piece of subdata $Y_i$ in M pieces of subdata, to obtain the first compressed data $Z_i'$ of the $i^{th}$ piece of subdata

S340: Send the first compressed data $Z_i'$ and third indication information on the first time-frequency resource

S350: Construct an $i^{th}$ piece of subdata $Y_i'$ based on the first compressed data $Z_i'$ and the third indication information

S360: Send second resource configuration information and/or third resource configuration information, where the second resource configuration information indicates a second time-frequency resource for transmitting second compressed data, and the third resource configuration information indicates a third time-frequency resource for transmitting third compressed data

S370: Perform data compression on the $i^{th}$ piece of subdata $Y_i$ in the M pieces of subdata, to obtain the second compressed data $Z_i''$ and/or the third compressed data $Z_i'''$ of the $i^{th}$ piece of subdata

S380: Send the second compressed data $Z_i''$ of the $i^{th}$ piece of subdata on the second time-frequency resource, and/or send the third compressed data $Z_i'''$ on the third time-frequency resource

S390: Update the constructed $i^{th}$ piece of subdata $Y_i'$

FIG. 17

Communication apparatus 400

Transceiver module 410

Processing module 420

FIG. 18

Communication apparatus 500

Processor 520

Memory 530

Transceiver 510

FIG. 19

## INTERNATIONAL SEARCH REPORT

| International application No. |
| --- |
| **PCT/CN2022/123574** |

| A. | CLASSIFICATION OF SUBJECT MATTER |
| --- | --- |

H04L27/00(2006.01)i; G06T9/00(2006.01)i; H04N19/10(2014.01)i

According to International Patent Classification (IPC) or to both national classification and IPC

| B. | FIELDS SEARCHED |
| --- | --- |

Minimum documentation searched (classification system followed by classification symbols)

    IPC: H04L G06T H04N

Documentation searched other than minimum documentation to the extent that such documents are included in the fields searched

Electronic data base consulted during the international search (name of data base and, where practicable, search terms used)

    CNABS; CNTXT; CNKI; VEN; USTXT; EPTXT; WOTXT: 压缩, 编码, 熵编码, 字典, 稀疏, 矩阵, 单元, 系数, 分解, 拆分, 源, 原始, 数据, 信号, 图像, 异或, compress+, cod+, encod+, entropy, dictionary, learning, sparse, matrix, coefficient, decompos +, divid+, source, original, data, signal, image

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| X | CN 106658003 A (TSINGHUA UNIVERSITY et al.) 10 May 2017 (2017-05-10) description, paragraphs [0092]-[0130], and figures 1-7 | 1-4, 12, 15-17, 23, 25-31 |
| X | CN 107845117 A (WUHAN UNIVERSITY) 27 March 2018 (2018-03-27) description, paragraphs [0054]-[0089], and figures 1-3 | 1-4, 12, 15-17, 23, 25-31 |
| X | CN 112184840 A (SHANGHAI JIAO TONG UNIVERSITY) 05 January 2021 (2021-01-05) description, paragraphs [0040]-[0069], and figures 1-3 | 1-4, 12, 15-17, 23, 25-31 |
| A | US 2020012932 A1 (NATIONAL CENTRAL UNIVERSITY) 09 January 2020 (2020-01-09) entire document | 1-31 |

☐ Further documents are listed in the continuation of Box C.     ☑ See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| **01 June 2023** | **15 June 2023** |

| Name and mailing address of the ISA/CN | Authorized officer |
| --- | --- |
| **China National Intellectual Property Administration (ISA/CN)** **China No. 6, Xitucheng Road, Jimenqiao, Haidian District, Beijing 100088** | |
| | Telephone No. |

Form PCT/ISA/210 (second sheet) (July 2022)

| Patent document cited in search report | | | Publication date (day/month/year) | Patent family member(s) | | | Publication date (day/month/year) |
|---|---|---|---|---|---|---|---|
| CN | 106658003 | A | 10 May 2017 | CN | 106658003 | B | 10 April 2018 |
| CN | 107845117 | A | 27 March 2018 | CN | 107845117 | B | 10 December 2019 |
| CN | 112184840 | A | 05 January 2021 | WO | 2022063055 | A1 | 31 March 2022 |
| | | | | CN | 112184840 | B | 02 September 2022 |
| US | 2020012932 | A1 | 09 January 2020 | TW | 202006612 | A | 01 February 2020 |
| | | | | TW | 667576 | B1 | 01 August 2019 |

Form PCT/ISA/210 (patent family annex) (July 2022)